(19)

Europäisches
Patentamt
European
Patent Office
Office européen
des brevets

(11)     **EP 2 641 996 A1**

(12)                    **EUROPEAN PATENT APPLICATION**

(43) Date of publication:
**25.09.2013 Bulletin 2013/39**

(21) Application number: **13001444.2**

(22) Date of filing: **20.03.2013**

(51) Int Cl.:
*C23C 16/18* (2006.01)        *C30B 25/16* (2006.01)
*C30B 25/18* (2006.01)        *C23C 16/40* (2006.01)
*C30B 29/22* (2006.01)        *C23C 16/52* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **23.03.2012 JP 2012066855
23.03.2012 JP 2012066858**

(71) Applicant: **Stanley Electric Co., Ltd.
Meguro-ku
Tokyo 153 (JP)**

(72) Inventors:
• **Sato, Yuka
Tokyo, 153-8636 (JP)**
• **Horio, Naochika
Tokyo, 153-8636 (JP)**

(74) Representative: **Carstens, Dirk Wilhelm
Wagner & Geyer
Gewürzmühlstrasse 5
80538 München (DE)**

(54)     **Method for growing magnesium-zinc-oxide-based crystal**

(57)     The method includes a step of growing a MgZnO-based single-crystal layer at a growth pressure of less than 10 kPa and a growth temperature equal to or greater than an upper limit temperature for ZnO single-crystal growth, wherein the MgZnO-based single-crystal layer is grown using a magnesium-based metal-organic compound having a cyclopentadienyl group, water vapor ($H_2O$) and a zinc-based metal-organic compound that does not contain oxygen.

EP 2 641 996 A1

**Description**

BACKGROUND OF THE INVENTION

1. Technical field

The present invention relates to a method for growing a magnesium-zinc-oxide (MgZnO) based crystal, and in particular, to a method for growing a MgZnO-based crystal by MOCVD.

2. Description of the Related Art

Zinc oxide (ZnO) is a direct-transition-type semiconductor having a bandgap energy of 3.37 eV at room temperature, and holds promise as a material for an optical element in the blue to purple regions. In particular, with an exciton binding energy of 60 meV and a refractive index of 2.0, zinc oxide has characteristics that are extremely suited to a semiconductor light-emitting element. It is suitable not only for light-emitting elements and light-receiving elements but also for a broad range of applications such as surface acoustic wave (SAW) devices and piezoelectric elements. Moreover, it has characteristics of being made from inexpensive raw materials and being harmless to the environment or the human body.

In general; metal organic chemical vapor deposition (MOCVD), molecular beam epitaxy (MBE), and pulsed laser deposition (PLD) are used as methods for growing a crystal for a zinc-oxide-based compound semiconductor. MBE is a method for growing a crystal under an ultra-high vacuum, and presents problems in that, e.g., costly equipment is required and the productivity is low. In contrast, MOCVD has advantages in that the equipment is relatively inexpensive, crystal growth can be performed over a large area, a plurality of crystals can be grown simultaneously, the throughput is high, and the method is excellent in terms of mass productivity and cost.

When manufacturing a semiconductor light-emitting element such as a light-emitting diode (LED), there is a need to form a so-called double-hetero structure in which the light-emitting layer is sandwiched between an n-type semiconductor layer and a p-type semiconductor layer having a wider band gap than that of the light-emitting layer to confine the carriers. For example, if the light-emitting layer is a ZnO crystal layer, MgZnO crystal layers are used for the p-type semiconductor layer and the n-type semiconductor layer. In an $Mg_xZn_{1-x}O$ crystal, the band gap can be increased while a Wurtzite structure as with a ZnO crystal is maintained if the Mg composition (x) is no more than 0.68.

Therefore, when manufacturing a semiconductor element such as a light- emitting diode, it is necessary to grow a high- quality $Mg_xZn_{1-x}O$ crystal. In relation to growing an MgZnO- based crystal, there is disclosed a method for, e.g., performing crystal growth using a polar oxygen material and a metal- organic compound that does not contain oxygen (Patent Document 1: Japanese Unexamined Patent Application Publication, JP- A 2010- 272807) . Patent Document 2 (JP- A 2006- 73726) discloses a method in which amorphous MgZnO film- formed at a low temperature is heat- treated and crystallized, and a MgZnO crystal is subsequently film- formed at a high temperature. Patent Document 3 (JP- A 2008- 244011) discloses a method for film- forming a ZnO crystal in which steps of growing a ZnO thin film at a low temperature and performing heat treatment at a high temperature in a reductive atmosphere are repeated. Patent Document 4 (JP- A 2008- 243987) and Patent Document 5 (JP- A 2010- 10629) disclose difficulties in growing ZnO- based crystal grown using MOCVD.

SUMMARY OF THE INVENTION

As described above, with regard to manufacturing a semiconductor element such as a light-emitting diode (LED), it is important to establish a method for growing a high-quality MgZnO crystal layer having excellent flatness and crystal orientation characteristics. Particularly important for obtaining p-type and n-type MgZnO crystal layers is establishment of a technique for growing an MgZnO crystal having a low residual carrier concentration.

A ZnO crystal has a hexagonal Wurtzite structure, and an MgO crystal has a cubic rock salt structure. An $Mg_xZn_{1-x}O$ crystal, which is a mixed crystal of the two above crystals, has a Wurtzite structure when the Mg composition (x) is between 0 and 0.68. If an MgZnO crystal is grown on a c-plane ZnO crystal, the a-axis length of the MgZnO crystal matches the a-axis length of the ZnO crystal; therefore, the a-axis length decreases and the c-axis length increases. In other words, the MgZnO crystal layer is a crystal that contains a strain.

With regard to growth of an MgZnO crystal using MOCVD, since a crystal strain is contained, the two-dimensional crystal growth process is even less stable than that of the ZnO crystal growth, and external factors (such as a defect or dislocation in the substrate crystal, a product that inhibits growth, residues on the substrate surface, minute crystal nucleus, etc.) cause problems such as (i) deterioration in flatness or disruption in crystal orientation, (ii) formation of pits and hillocks, and (iii) an increase in residue carrier concentration.

P- type and n- type semiconductor layers are formed by supplying a material gas containing an impurity element during crystal growth. The material gas containing an impurity element is subjected to a thermal decomposition reaction and then incorporated into the $Mg_xZn_{1-x}O$ crystal layer, as with the zinc- based organometalic material gas, magnesium-based organometalic material gas, and water vapor. At this time, the impurity element replaces the Zn site, the Mg site or the O (oxygen) site. However, the impurity element readily forms, with oxygen, oxide crystals having a variety of crystal structures, and may disrupt the crystal structure of the $Mg_xZn_{1-x}O$ crystal layer. The impurity element therefore causes problems similar to those described above in (i)- (iii) . Also, it is important, when the carrier concentration in the semiconductor layer is adjusted, that the residual carrier concentration in the semiconductor layer is sufficiently lower than the carrier concentration to be adjusted.

The present invention was conceived in light of the abovementioned problems, it being an object thereof to provide a method for growing, on a ZnO single-crystal, an MgZnO crystal layer having suppressed formation of random pits and hillocks, an excellent flatness and crystal orientation, and a low residual carrier concentration and a high quality.

Another object of the present invention is to provide a method for growing an impurity-doped MgZnO crystal having a good flatness and crystal orientation, suppressed formation of random pits and hillocks, and a high carrier concentration and a high quality.

According to the present invention, there is provided a method for growing a magnesium- zinc- oxide (MgZnO)-based crystal on a zinc oxide (ZnO)- based crystal by MOCVD; the method comprising:

growing an MgZnO-based single-crystal layer at a growth pressure of less than 10 kPa and a growth temperature equal to or greater than an upper limit temperature for ZnO single-crystal growth,
wherein the MgZnO-based single-crystal layer is grown using a magnesium-based metal-organic compound having a Cp group, water vapor ($H_2O$ and a zinc-based metal-organic compound that does not contain oxygen.

BRIEF DESCRIPTION OF THE DRAWINGS

FIG. 1 schematically illustrates the configuration of an MOCVD system used for crystal growth;
FIG. 2 shows a crystal growth sequence;
FIG. 3 is a cross-section view showing the configuration of a growth layer in which a ZnO single-crystal layer and an MgZnO single-crystal layer are grown on a substrate;
FIG. 4 shows AFM images of the MgZnO growth layers according to a first embodiment;
FIG. 5 shows differential-interference microscope images of the MgZnO growth layers according to the first embodiment;
FIG. 6A shows the $2\theta$ diffraction curve of the (0002)- plane of each growth layer in the first embodiment, and FIG. 6B shows the rocking curve of the (100)- plane of each growth layer;
FIG. 7 shows the reciprocal lattice mapping of the (105)- plane of each growth layer in the first embodiment;
FIG. 8 shows the relationship between the Mg composition (x) and the c-axis length;
FIG. 9 shows the carrier concentration in the depth direction obtained by CV measurement;
FIG. 10A shows the relationship between the Mg composition (x) and the growth rate (GR) with respect to the growth temperature, and FIG. 10B shows the relationship between the half-width (FWHM) of the (100) rocking curve and the carrier concentration with respect to the growth temperature;
FIG. 11 shows AFM images of MgZnO growth layers according to a second embodiment;
FIG. 12 shows (100)- plane rocking curves and differential- interference microscope images of the MgZnO crystal layers according to the second embodiment;
FIG. 13 shows AFM images of MgZnO growth layers according to a third embodiment;
FIG. 14 shows (100)- plane rocking curves of the MgZnO growth layers according to the third embodiment;
FIG. 15 shows the relationship between the growth pressure (Pg) and the Mg composition (x) and between the growth pressure (Pg) and the growth rate (GR) according to the third embodiment;
FIG. 16 shows AFM images of MgZnO growth layers according to a fourth embodiment;
FIG. 17 shows (100)- plane rocking curves of the MgZnO growth layers according to the fourth embodiment;
FIG. 18 shows the relationship between the group II glow rate and the Mg composition (x) and between the group II glow rate and the growth rate (GR) according to the fourth embodiment;
FIG. 19 shows AFM images of growth layers of comparative example-1;
FIG. 20 shows (100)- plane rocking curves and differential- interference microscope images of the growth layers of the comparative example- 1;
FIG. 21 shows AFM images of MgZnO growth layers of comparative example 2;
FIG. 22 shows differential-interference microscope images of the growth layers of the comparative example-2;
FIG. 23 shows the (100)- plane rocking curves of the MgZnO crystal layers of the comparative example- 2;

FIG. 24 shows AFM images of MgZnO growth layers of comparative example-3;

FIG. 25 shows differential-interference microscope images of the growth layers of the comparative example-3;

FIG. 26 shows $2\theta$ and $(100)\omega$ rocking curves of the MgZnO crystal layers of the comparative example-3;

FIG. 27 shows AFM images of growth layers of comparative example-4;

FIG. 28 shows (100)- plane rocking curves of the MgZnO crystal layers of the comparative example- 4;

FIG. 29 shows the relationships between the growth temperature and the Mg composition (x) in the embodiments and the comparative examples of the present invention;

FIG. 30 shows the crystal growth sequence according to the fifth embodiment of the present invention;

FIG. 31 shows the results of evaluations performed on the growth layers according to the fifth embodiment;

FIGS. 32A, 32B, 32C, and 32D show the result of measuring the $2\theta$ rocking curve of the (002)- plane, the AFM image, the rocking curve of the (100)- plane, and CV measurement results of the undoped MgZnO crystal layer according to the fifth embodiment;

FIGS. 33A, 33B, 33C and 33D respectively show the results of measuring the $2\theta$ rocking curve of the (002)- plane, the rocking curve of the (100)- plane, the AFM image, and CV measurement results of the Ga- doped MgZnO crystal layer (Ng value: $9.7 \times 10^{-6}$) according to the fifth embodiment;

FIG. 34 shows the SIMS depth-direction analysis results when the TEGa flow rate F(TEGa) is 0.3 nmol/min (Ng value: $9.7 \times 10^{-6}$) in the fifth embodiment;

FIGS. 35A, 35B and 35C respectively show the measurement results of the $2\theta$ rocking curve of the (002)- plane, the rocking curve of the (100)- plane, and the AFM image when the TEGa flow rate F (TEGa) is 0.90 nmol/min (Ng value: $29 \times 10^{-6}$) according to the fifth embodiment;

FIG. 36 shows the relationship between the Ng value and the Ga doping concentration according to the fifth embodiment;

FIG. 37 shows the relationship between the Ga doping concentration and the n-type carrier concentration according to the fifth embodiment;

FIG. 38 shows the relationship between the growth temperature Tg and the Ga doping concentration and between the growth temperature Tg and the n-type carrier concentration;

FIG. 39 shows the results of evaluations performed on the undoped and Ga-doped MgZnO crystal growth layers of a comparative example 5;

FIGS. 40A, 40B and 40C respectively show the results of measuring the $2\theta$ rocking curve of the (002)- plane, the AFM image, and the rocking curve of the (100)- plane when the TEGa flow rate F (TEGa) is 0.1 nmol/min (Ng value: $9.5 \times 10^{-6}$) according to the comparative example 5;

FIG. 41 shows the relationship between the Ga doping concentration and the Ng value of the comparative example 5; and

FIG. 42 shows the SIMS depth-direction analysis results when the TEGa flow rate F(TEGa) is 0.1 nmol/min (Ng value: $9.5 \times 10^{-6}$) in the comparative example 5.

<u>Detailed Description of the Invention</u>

A detailed description will now be given, with reference to the accompanying drawings, for a method for growing a magnesium- zinc- oxide ($Mg_xZn_{1-x}O$)- based semiconductor crystal layer having an excellent single- crystallinity and flatness in a ZnO single- crystal substrate using MOCVD. A description will also be given further below for comparative examples used to describe the features of the growth method and the growth layer, configuration, and effect of the embodiments.

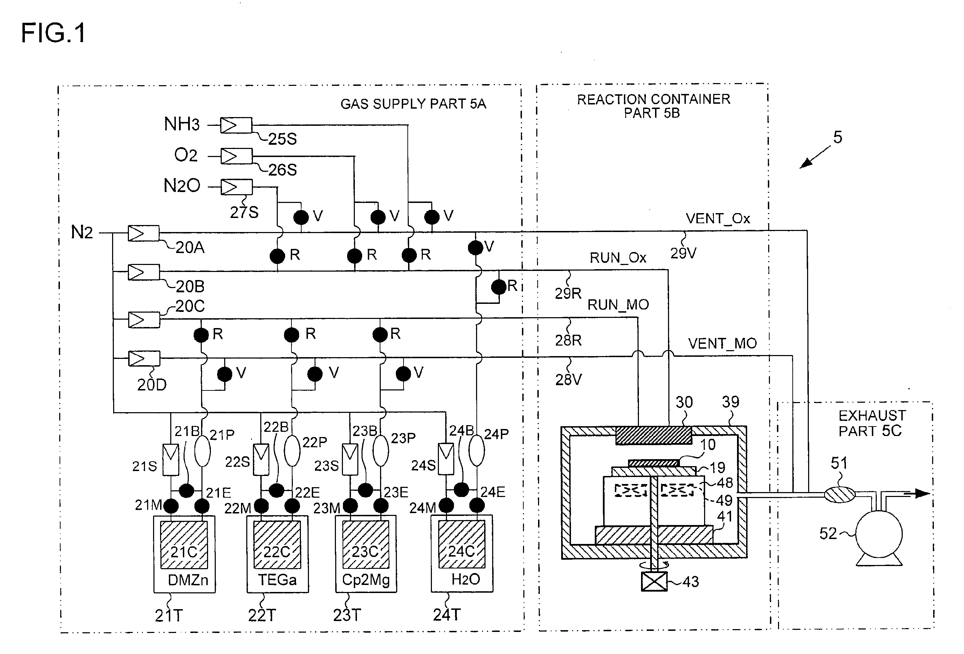

FIG. 1 schematically illustrates the configuration of an MOCVD system 5 used for crystal growth in the present invention. A description will now be given for the details of the device configuration of the MOCVD system 5. Crystal growth materials will be described further below.

[Device configuration]

The MOCVD system 5 comprises a gas supplying part 5A, a reaction container part 5B, and an exhaust part 5C. The gas supplying part 5A comprises a portion for vaporizing and supplying a metal-organic compound material gas, a portion for supplying gaseous material gas, and a transport unit provided with a function for transporting the gases.

The metal-organic compound material gas, which is liquid (or solid) at room temperature, is vaporized and fed as water vapor. In the present embodiment, dimethylzinc (DMZn), bis cyclopentadienyl magnesium (Cp2Mg), and triethylgallium (TEGa) are respectively used as a zinc (Zn) source, a magnesium (Mg) source, and a gallium (Ga) source.

A description will first be given with regard to a supply of DMZn. As shown in FIG. 1, nitrogen gas is set to a predetermined flow rate by a flow rate adjustment device (mass flow controller) 21S and fed into a DMZn housing container 21C through a gas feed valve 21M, and the nitrogen gas is saturated with DMZn vapor. The DMZn-saturated nitrogen gas is fed, through an extraction valve 21E and a pressure adjustment device 21P, to a first vent pipe (hereafter, referred to as a VENT-MO line) 28V during standby for growth or to a first run pipe (hereafter, referred to as a RUN-MO line) 28R during growth. Here, the internal pressure in the housing container is adjusted to a constant pressure using a pressure adjustment device 21P. The DMZn housing container is kept at a constant temperature by a thermostatic bath 21T.

The other metal-organic compound material gases Cp2Mg and TEGa are also fed in a similar manner. Specifically, nitrogen gas is fed at a predetermined flow rate through a flow rate adjustment device 22S, 23S into a housing container 22C (TEGa) and 23C (Cp2Mg) housing the respective materials, and the corresponding gas is fed, through an extraction valve 22E, 23E and a pressure adjustment device 22P, 23P to a VENT-MO line (VENT1) 28V during standby for growth or to a RUN-MO line 28R during growth.

With regard to water ($H_2O$), which is the liquid material functioning as an oxygen source, a predetermined flow rate of nitrogen gas is sent through a flow rate adjustment device 24S into a housing container 24C, the nitrogen gas is saturated with water vapor, and fed, through an extraction valve 24E and a pressure adjustment device 24P, to a second vent pipe (hereafter, referred to as a VENT-Ox line) 29V during standby for growth or to a second run pipe (hereafter, referred to as a RUN-Ox line) 29R during growth.

Ammonia ($NH_3$) gas, which is a gaseous material, is used for the p-type impurity source. The $NH_3$ gas is fed at a predetermined flow rate by the flow rate adjustment device 25S. The $NH_3$ gas is fed to the VENT-Ox line 29V during standby, and to the RUN-Ox line 29R during growth. The gas may also be diluted by an inert gas such as nitrogen or argon (Ar).

The vapor of the above liquid or solid materials and the gaseous material (hereafter, referred to as material gas) is fed through the RUN-MO line 28R and the RUN-Ox line 29R to a shower head 30 of the reaction container part 5B. A flow  rate adjustment device 20C, 20B is also provided to each of the RUN-MO line 28R and the RUN-Ox line 29R. The material gas is delivered by a carrier gas (nitrogen gas) to the shower head 30 mounted on the upper part of a reaction container (chamber) 39.

The shower head 30 has a discharge surface facing the main surface (growth surface) of a substrate 10. Numerous discharge holes are arranged along the discharge surface. A configuration is adopted so that the metal-organic compound material gas and $H_2O$ are discharged towards the substrate 10 from individual holes.

The shower head 30 for blowing the material gas onto the substrate 10, the substrate 10, a susceptor 19 for supporting the substrate 10, and a heater 49 for heating the susceptor 19 are installed in the reaction container 39. The system includes a structure with which the substrate can be heated from room temperature to about 1100°C by the heater 49.

The substrate temperature in the present embodiment refers to the temperature of the surface of the susceptor 19 on which the substrate is placed. Specifically, in the case of MOCVD, transmission of heat-from the susceptor 19 to the substrate 10 takes place through direct contact and through the gas present between the susceptor 19 and the substrate 10. In the growth pressure range of 1kPa to 120 kPa (Pa: pascals) used in the present embodiment, the surface temperature of the substrate 10 (i.e., the growth temperature) is about 0°C to 10°C lower than the surface  temperature of the susceptor 19.

A rotation mechanism for causing the susceptor 19 to rotate is provided to the reaction container 39. More specifically, the susceptor 19 is supported by a susceptor support cylinder 48, and the susceptor support cylinder 48 is rotatably supported on a stage 41. A rotation motor 43 causes the susceptor support cylinder 48 to rotate, thereby causing the susceptor 19 (i.e., the substrate 10) to rotate. The abovementioned heater 49 is installed in the susceptor support cylinder 48.

The exhaust part 5C comprises a container interior pressure adjustment device 51 and an exhaust pump 52, and is structured so that the container interior pressure adjustment device 51 is capable of adjusting the pressure in the reaction container 39 between 0.01 kPa to about 120 kPa.


[Crystal growth material]


In the present invention, a zinc-based metal-organic compound that does not contain oxygen in the constituent molecule and a magnesium-based metal-organic compound having a Cp group (cyclopentadienyl group) are used as the metal-organic compound material gas (or organic metal material); and water vapor ($H_2O$) is used as the oxygen source.

A metal- organic compound that does not contain oxygen is highly reactive with $H_2O$, and enables ZnO- based crystals even in regions in which the growth pressure is low or in which the VI/II ratio or the flow rate ratio (F (H2O) /F (MO) ratio) between the water vapor and the metal- organic compound (MO)  is low.

In order to utilize the growth catalyst action described further below, a magnesium-based metal-organic compound having a Cp group (cyclopentadienyl group) is used. In order to prevent metal-organic compounds other than the magnesium-based metal-organic compound from interfering with the catalyst function, the functional group of metal-organic compounds other than the magnesium-based metal-organic compound is preferably a chained hydrocarbon group.

More specifically, although DMZn, Cp2Mg, and TEGa are used as the metal-organic compound material gas, diethylzinc (DEZn) or another substance may be used as the Zn material. Also, for the magnesium-based metal-organic compound having a Cp group (cyclopentadienyl group), bismethylpentadienyl magnesium (MeCp2Mg), bisethylpentadienyl magnesium (EtCp2Mg), or another substance may be used other than Cp2Mg.

Water vapor ($H_2O$) is used as the oxygen material. $H_2O$ turns into active oxygen after supplying hydrogen through the reaction catalyst function described further below, and is therefore the most suitable oxidant for the method of the present invention.

Trimethylgallium (TMGa), triethylgallium (TEGa), trimethylaluminum (TMAl), triethylaluminum (TEAl), triisobutylaluminum (TIBA), or another substance can be used as an impurity doping material (group III material).

Ammonia ($NH_3$), hydrazine (Hy), monomethylhydrazine (MMHy), dimethylhydrazine (DMHy), or another substance can be used as a group V material for an impurity.

An inert gas such as nitrogen ($N_2$), argon (Ar), xenon (Xe), or helium (He) can be used as the carrier gas. Nitrogen ($N_2$) is the most suitable for the carrier gas when gas purity and cost are taken into account. In the present invention, the growth catalyst function of Cp2Mg is used. Using hydrogen ($H_2$) for the carrier gas will reduce the growth catalyst effect and is therefore not desirable, but use is possible as long as the quantity is small.

A "0.5°- offset substrate", in which the (0001)- plane is tilted by 0.5° in the [10- 10] direction (or a 0.5°- offset substrate in which the c- plane is tilted by 0.5° in the m- axis direction), and a (0001) just substrate are used for the substrate. In the embodiments and comparative examples described below, a ZnO single- crystal substrate in which the FWHM of the XRD (100) ω rocking curve is less than 40 arcsecs.

[Growth method for first to fourth embodiments and comparative example-1 to comparative example-4]

With regard to the first to fourth embodiments and comparative example-1 to comparative example-4, a description will be given for growth of an undoped MgZnO crystal. More specifically, with regard to the first embodiment, a description will be given for growth of an undoped MgZnO crystal for a representative embodiment of the present invention (i.e., growth temperature of 850 to 900°C). With regard to the second embodiment, a description will be given for growth in an instance in which the growth temperature range is expanded, i.e., in an instance in which the growth temperature is 775 to 925°C. With regard to the third embodiment, a description will be given for growth in an instance in which the growth pressure is 2 to 40 kPa. With regard to the fourth embodiment, a description will be given for growth in instances between which the flow rate of group II (or, group-II flow rate magnification described further below) is different.

First embodiment

[Growth method for first embodiment]

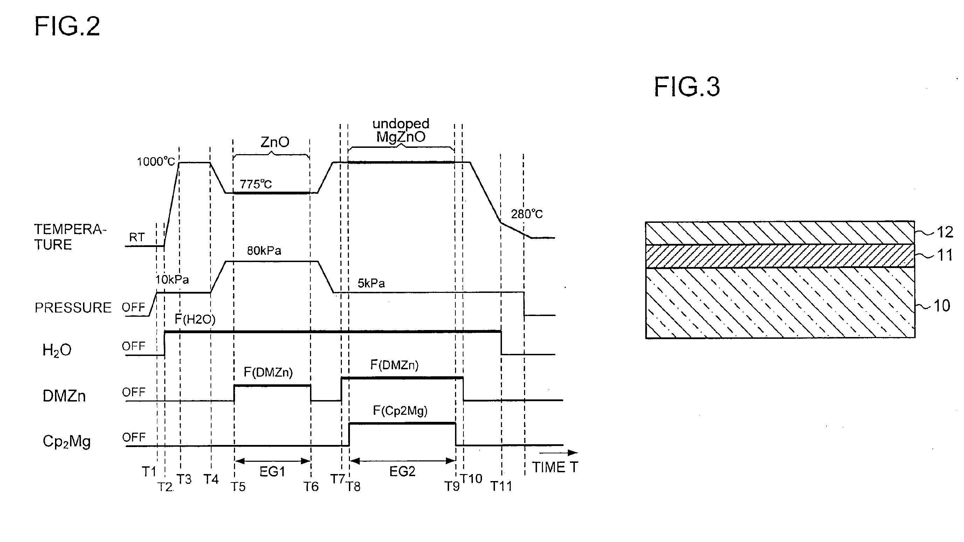

A detailed description will now be given for a growth method according to the first embodiment, with reference to the crystal growth sequence shown in FIG. 2.

First, a ZnO single- crystal substrate 10 having a surface layer that has been etched (may be hereafter referred to as a ZnO substrate, or simply as a substrate) was positioned on the susceptor 19 in the reaction container 39. Air was discharged until a state of vacuum is reached, then the pressure in the reaction container was adjusted to 10 kPa (i.e., at time T=T1). The ZnO substrate 10 was rotated at a rotation speed of 10 rpm by a rotation mechanism. Nitrogen ($N_2$) gas was fed from the shower head 30 to the ZnO substrate 10 from each of the RUN- MO line 28R and the RUN- Ox line 29R at a flow rate of 2 liters/min (total 4 liters/min).

Next, when the pressure in the reaction container 39 had stabilized at 10 kPa, the substrate temperature was increased from room temperature (RT), nitrogen gas was fed at 2 liters/min from the RUN- MO line 28R as the carrier gas, the flow rate F (H2O) of water vapor ($H_2O$) was adjusted to 800 μmol/min, and the water vapor was fed to the ZnO substrate 10 from the RUN- Ox line 29R at a flow rate, combined with the carrier gas, of 2 liters/min. Heat treatment was then performed for 7 minutes at a substrate temperature of 1000°C (T=T3 to T4).

Next, the pressure in the reaction container 39 was increased from 10 kPa, and the substrate temperature was increased (T=T4). When the growth pressure Pg had stabilized at 80 kPa and the substrate temperature Tg had stabilized at a predetermined growth temperature of 775°C, the flow rate F (DMZn) of the DMZn was adjusted to 10 μmol/min, the DMZn was fed to the ZnO substrate 10 at a flow rate, combined with the nitrogen gas serving as the carrier gas, of 2 liters/min, and crystal growth was commenced (T=T5). A ZnO crystal layer 11 having a thickness of approximately 0.2 μm was grown on the ZnO substrate with a growth time of 24 minutes (i.e., T=T5 to T6, growth time: EG1 = 24 min).

Next, an increase in substrate temperature and a decrease in pressure were commenced. When the growth pressure Pg had stabilized at 5 kPa and the substrate temperature had stabilized at growth temperature Tg=875°C, DMZn (flow rate: 30 μmol/min) and Cp2Mg (flow rate F (Cp2Mg) : 1.00 μmol/min) were sequentially fed from the RUN-MO line 28R (i.e., T=7 and T=8, respectively) . During this time, a total flow rate, for the MO gas and the carrier gas (nitrogen), of 2 liters/min was maintained. Also, $H_2O$ (flow rate: 800 $\mu$mol/min) was fed from the RUN- Ox line 29R to the ZnO substrate 10 at a flow rate, combined with the carrier gas, of 2 liters/min. When 480 minutes have elapsed (T=T9) from the start of growth (T=T8), supply of Cp2Mg was stopped (T=T9) and then supply of DMZn was stopped (T=T10), and an undoped MgZnO crystal layer 12 having a thickness of approximately 500 nm was grown on the ZnO crystal layer 11 (i.e., T=T8 to T9, growth time: EG2 = 480 min) .

In order to facilitate comprehension and description, the group-II flow rate magnification MF(II) is defined as follows. As described above, the flow rates of group II in the growth of the MgZnO crystal layer 12 were (F(DMZn), F(Cp2Mg)) = (30 $\mu$mol/min, 1.00 $\mu$mol/min). The group-II flow rate magnification MF(II) is defined using, as a unit flow rate, a flow rate corresponding to one third of these group II flow rates, i.e., (F(DMZn), F(Cp2Mg)) = (10 $\mu$mol/min, 0.334 $\mu$mol/min). The group-II flow rate magnification MF(II) will be represented as MF(II)=1, 2, 3, or $\times$1, $\times$2, $\times$3. Accordingly, in the case of the first embodiment, the group-II flow rate magnification MF(II) = 3 (or x3).

In the first embodiment, the water vapor area- flow- rate FS (H2O) is 18.1 $\mu$mol$\cdot$min$^{-1}\cdot$cm$^{-2}$. The water vapor area- flow- rate FS (H2O) is defined as the molar flow rate per unit area of water vapor ($H_2O$) fed to the ZnO substrate 10. Specifically, the water vapor area- flow- rate FS (H2O) is a value obtained by dividing the flow rate of $H_2O$ by the area of the gas discharge surface (i.e., effective discharge area) of the shower head 30. Specifically, when the diameter of the discharge surface of the shower head 30 is represented by d, the water vapor area- flow- rate FS (H2O) = $H_2O$ flow rate (F (H2O) ) / ($\pi \times$ (d/ 2)$^2$) . In the present embodiments, d = 75.

When the growth is complete, cooling was performed until the substrate temperature fell to 280°C while water vapor ($H_2O$) was fed, while the pressure was maintained at 5 kPa (T=T10 to T11). Then, the pressure was reduced to pump vacuum (about 10$^{-1}$ Pa), and at the same time, supply of $H_2O$ was discontinued. The temperature of the substrate was then allowed to fall to room temperature, and the growth was completed.

[Growth conditions for first embodiment]

The growth method was described above for an example in which the growth temperature Tg is 875°C. In the first embodiment, the MgZnO crystal layer 12 was grown on the ZnO crystal layer 11 with different growth temperatures Tg. Specifically, crystals were grown at five different growth temperatures Tg: 850°C, 863°C, 875°C, 888°C, and 900°C. Pre-growth heat treatment, growth of the ZnO crystal layer 11, and other steps were performed in the same manner as described above. In addition, the growth pressure, growth time, and other parameters were the same as described above for growth of the MgZnO crystal layer 12, except that the growth temperatures Tg were different.

As described above, in the first embodiment, DMZn, which is a zinc-based organometal (i.e., metal-organic compound) that does not contain oxygen in the constituent molecule, and Cp2Mg, which is a magnesium-based metal-organic compound having a Cp group, were used as the metal-organic (MO) materials, water vapor ($H_2O$) was used as the oxygen source, and the undoped MgZnO crystal layers 12 were grown under the following conditions.

 (i) Growth temperature Tg = 850°C, 863°C, 875°C, 888°C, 900°C
 (ii) Growth pressure Pg = 5 kPa
 (iii) Group-II flow rate magnification MF(II): $\times$3
 (iv) Growth time: 480 min.

Second embodiment

[Growth method for second embodiment]

Other than growth of the MgZnO crystal layer 12, growth conditions such as those for the pre-growth heat treatment and the growth of the ZnO crystal layer 11 are identical to those in the first embodiment. Therefore, a description will be given below for the growth of the MgZnO crystal layer 12.

Specifically, the MgZnO crystal layer 12 was grown at a growth pressure Pg of 5 kPa and at different growth temperatures. Specifically, DMZn (flow rate: 30 $\mu$mol/min) and Cp2Mg (1.00 $\mu$mol/min) were fed from the RUN- MO line 28R, and $H_2O$ (flow rate: 800 $\mu$mol/min) was fed from the RUN- Ox line 29R to the ZnO substrate 10 at a flow rate, combined with the carrier gas, of 2 liters/min. The MgZnO crystal layer 12 was growth on the ZnO crystal layer 11 over a growth time of 120 minutes. Growth was performed at different growth temperatures Tg: 775°C, 825°C, 875°C, and 925°C. The layer thicknesses of the MgZnO crystal layer 12 were 60- 1000 nm.

[Growth conditions for second embodiment]

In the second embodiment, the MgZnO crystal layer 12 was grown on the ZnO crystal layer 11 with different growth temperatures Tg. Other than the fact that the growth time of the MgZnO crystal layer 12 was less than the growth time according to the first embodiment, other growth conditions were identical to those in the first embodiment. The water vapor area- flow- rate FS (H2O) was also identical to that in the first embodiment, at 18.1 $\mu$mol·min$^{-1}$·cm$^{-2}$.

In other words, in the second embodiment, DMZn and Cp2Mg were used as the metal-organic (MO) materials; water vapor ($H_2O$) was used as the oxygen source, and the undoped MgZnO crystal layers 12 were grown under the following conditions.

(i) Growth temperature Tg = 775°C, 825°C, 875°C, and 925°C
(ii) Growth pressure Pg = 5 kPa
(iii) Group-II flow rate magnification MF(II): $\times$3
(iv) Growth time: 120 min.

Third embodiment

[Growth method for third embodiment]

Differences with respect to the first embodiment will be described below. Specifically, heat treatment of the substrate was performed with the flow rate of water vapor ($H_2O$) being 640 $\mu$mol/min.

The ZnO crystal layer 11 was grown at a growth pressure Pg of 80 kPa and a growth temperature Tg of 775°C. The flow rate of DMZn was 10 $\mu$mol/min and the flow rate of $H_2O$ was 640 $\mu$mol/min. A ZnO crystal layer 11 having a thickness of approximately 0.2 $\mu$m was grown on the ZnO substrate 10 with a growth time of 24 minutes.

The MgZnO crystal layer 12 was grown at a growth temperature Tg of 875°C. The flow rate of DMZn was 10 $\mu$mol/min, the flow rate of Cp2Mg was 0.334 $\mu$mol/min, and the flow rate of $H_2O$ was 640 $\mu$mol/min. Growth was performed at five different growth pressures Pg: 2 kPa, 5 kPa, 10 kPa, 20 kPa, and 40 kPa. The layer thickness of the MgZnO crystal layer 12 was 20 to 30 nm.

[Growth conditions for third embodiment]

In other words, in the third embodiment, DMZn and Cp2Mg were used as the metal-organic (MO) materials; and water vapor ($H_2O$) was used as the oxygen source, and the undoped MgZnO crystal layers 12 were grown under the following conditions.

(i) Growth pressure Pg: 2 kPa, 5 kPa, 10 kPa, 20 kPa, and 40 kPa
(ii) Growth temperature Tg = 875°C
(iii) Group-II flow rate magnification MF(II): $\times$1
(iv) Growth time: 120 min.

Fourth embodiment

The heat treatment of the substrate and the method for growing the ZnO crystal layer 11 are identical to those according to the third embodiment; therefore, a description will be given below with regard to the growth of the MgZnO crystal layer 12.

Specifically, the MgZnO crystal layer 12 was grown for 120 minutes at a growth temperature Tg of 875°C and a growth pressure Pg of 5 kPa. In the fourth embodiment, growth was performed for four different group- II (DMZn, Cp2Mg) flow rates: (F (DMZn), F (Cp2Mg) ) = (10 $\mu$mol/min, 0.334 $\mu$mol/min), (20 $\mu$mol/min, 0.669 $\mu$mol/min), (30 $\mu$mol/min, 1.00 $\mu$mol/min) and (40 $\mu$mol/min, 1.33 $\mu$mol/min) . The group- II flow rate magnifications MF (II) of the abovementioned group II substances were MF (II) =1, 2, 3, and 4 (also represented as $\times$1, $\times$2, $\times$3, $\times$4), respectively. The layer thickness of the MgZnO crystal layers 12 were 20- 110 nm.

In other words, in the fourth embodiment, DMZn and Cp2Mg were used as the metal-organic (MO) materials, water vapor ($H_2O$) was fed at flow rate F(H2O) = 640 $\mu$mol/min (or F(H2O) = 800 $\mu$mol/min in the instance of MF(II)=4) as the oxygen source, and the undoped MgZnO crystal layers 12 were grown under the following conditions.

(i) Growth temperature Tg = 875°C
(ii) Growth pressure Pg = 5 kPa
(iii) Group-II flow rate magnification MF(II): $\times$1, $\times$2, $\times$3, $\times$4
(iv) Growth time: 120 min.

Comparative examples-1 through 4

In order to evaluate the MgZnO crystal layers grown in the first through fourth embodiments, crystals were grown as comparative examples according to the flowing growth method and conditions. More specifically, comparative example-1 is a representative example of growth (i.e., growth temperature: 775°C), comparative example-2 is an example of growth in an instance in which the growth temperature range is 700-850°C, comparative example-3 is an example of growth in an instance in which the growth pressure range is 10-40 kPa, and comparative example-4 is an example of growth in an instance in which the flow rate of the group II material are varied.

As with the first through fourth embodiments, a ZnO single-crystal substrate in which the FWHM of the XRD $(100)\omega$ rocking curve is less than 40 arcsecs was used as the substrate, and the surface layer was subjected to etching treatment. The growth sequence was also similar to that according to the first through fourth embodiments other than the points described below. Differences with respect to the first through fourth embodiments will be mainly described below.

Comparative example-1

For the substrate heat treatment, the substrate temperature was 800°C and the pressure was 10 kPa. Simultaneous with the start of temperature increase, nitrogen gas was fed as the carrier gas from the RUN-MO line 28R at 2 liters/min. The flow rate F(H2O) of water vapor ($H_2O$) was adjusted to 640 $\mu$mol/min, and water vapor was fed to the ZnO substrate 10 from the RUN-Ox line 29R at a flow rate, combined with the carrier gas, of 2 liters/min. Then, heat treatment was performed for 7 minutes at a substrate temperature of 800°C.

The ZnO crystal layer 11 was grown at a growth temperature Tg of 800°C and a growth pressure Pg of 80 kPa. The flow rate of DMZn was 10 $\mu$mol/min, and the flow rate of Cp2Mg was 640 $\mu$mol/min. A ZnO crystal layer 11 having a thickness of approximately 0.2 $\mu$m was then grown on the ZnO substrate 10 over a growth time of 24 minutes.

The MgZnO crystal layer 12 was grown at a growth temperature Tg of 775°C and a growth pressure Pg of 10 kPa. The flow rate of DMZn was 10 $\mu$mol/min, and the flow rate of Cp2Mg was 0.556 $\mu$mol/min. The MgZnO crystal layer 12 was then grown on the ZnO crystal layer 11 over a growth time of 120 minutes.

In comparative example-1, growth was performed with varying $H_2O$ flow rates and at different VI/II ratios. Specifically, the undoped MgZnO crystal layers 12 were grown using $H_2O$ flow rates of 40 $\mu$mol/min (VI/II ratio: 3.8), 80 $\mu$mol/min (VI/II ratio: 7.6), 160 $\mu$mol/min (VI/II ratio: 15.2), and 640 $\mu$mol/min (VI/II ratio: 60.6). The layer thickness of the MgZnO crystal layers 12 were 60-240 nm.

Comparative example-2

Other than the growth of the MgZnO crystal layer 12, growth conditions such as those for the pre-growth heat treatment of the growth substrate and the growth of the ZnO crystal layer 11 were identical to those of comparative example-1; therefore, a description will be given below with regard to the growth of the MgZnO crystal layer 12.

The MgZnO crystal layer 12 was grown at a growth pressure Pg of 10 kPa and at different growth temperatures Tg. The flow rate of DMZn was 10 $\mu$mol/min, the flow rate of Cp2Mg was 0.556 $\mu$mol/min, and the flow rate of $H_2O$ was 640 $\mu$mol/min. Specifically, growth was performed at each growth temperature Tg of 700°C, 750°C, 775°C, 800°C, 825°C, and 850°C. An undoped MgZnO crystal layer 12 having a film thickness of 35-600 nm was then grown on the ZnO crystal layer 11 over a growth time of 120 minutes.

Comparative example-3

Other than the growth of the MgZnO crystal layer 12, growth conditions such as those for the pre-growth heat treatment of the growth substrate and the growth of the ZnO crystal layer 11 were identical to those of comparative example-1; therefore, a description will be given below with regard to the growth of the MgZnO crystal layer 12.

The MgZnO crystal layer 12 was grown at a growth temperature Tg of 800°C and at different growth pressures Pg. The flow rate of DMZn was 10 $\mu$mol/min, the flow rate of Cp2Mg was 0.556 $\mu$mol/min, and the flow rate of $H_2O$ was 640 $\mu$mol/min. Specifically, growth was performed at each growth pressure Pg of 10 kPa, 20 kPa, and 40 kPa. Undoped MgZnO crystal layers 12 each having a film thickness of 250 nm were then grown on the ZnO crystal layer 11 over a growth time of 120 minutes.

Comparative example-4

Other than the growth of the MgZnO crystal layer 12, growth conditions such as those for the pre-growth heat treatment of the growth substrate and the growth of the ZnO crystal layer 11 were identical to those of comparative example-1; therefore, a description will be given below with regard to the growth of the MgZnO crystal layer 12.

The MgZnO crystal layer 12 was grown at a growth temperature Tg of 775°C and a growth pressure Pg of 10 kPa, and over a growth time of 120 minutes. In comparative example-4, growth was performed for three instances in which the total flow rate F (II+VI) of the group-II (DMZn, Cp2Mg) flow rate and the VI group ($H_2O$), i.e., the total flow rate F (II+VI) of the material gas, is different. More specifically, growth was performed for instances in which (DMZn, Cp2Mg, $H_2O$) is (10 $\mu$mol/min, 0.556 $\mu$mol/min, 40 $\mu$mol/min), (20 $\mu$mol/min, 1.11 $\mu$mol/min, 80 $\mu$mol/min), and (30 $\mu$mol/min, 1.66 $\mu$mol/min, 120 $\mu$mol/min). The total flow rate magnification MF (II+VI) of the material gas is defined using, as a unit flow rate, the flow rate (10 $\mu$mol/min, 0.556 $\mu$mol/min, 40 $\mu$mol/min) of the abovementioned material gas (II-group and VI-group gases). In other words, in the case of comparative examples-1, 2, and 3, the total flow rate magnification MF (II+IV) of the material gas is 1, and in the case of comparative example-4, MF(II+VI) is 1, 2, and 3 (also represented as ×1, x2, and ×3).

[Crystal growth mechanism of the present invention]

The present invention was conceived from knowledge obtained as a result of investigation and research in relation to the growth of MgZnO-based crystals. As described above, in the method for growing an MgZnO-based crystal according to the present invention, a zinc-based organometal that does not contain oxygen in the constituent molecule, and a magnesium-based metal-organic compound are used as metal-organic (MO) materials; water vapor ($H_2O$) is used as an oxygen source; and the MgZnO-based crystal is grown under a non-reductive atmosphere (or nitrogen atmosphere).

Conventionally, when a ternary mixed crystal such as $Mg_xZn_{1-x}O$ is grown, means in which the Mg composition (x) is increased based on ZnO- crystal growth conditions is employed. For example, the method for growing a MgZnO crystal disclosed in Patent Document 1 also employs such means, and the crystal quality is improved while unnecessary reaction is suppressed using reduced- pressure growth (or low- pressure growth) and a low water vapor flow rate.

A ZnO growth system in which DMZn and water vapor are used and in which growth is performed in a nitrogen atmosphere is a non-reductive-atmosphere reaction system in which hydrogen is not present. DMZn, which has a chain hydrocarbon, releases the chain hydrocarbon upon reacting with water vapour, even in a non-reductive atmosphere, and the generated active zinc and water vapor react and grow a ZnO crystal. At this time, the chain hydrocarbon is released (or desorbed) away from the growth surface without disrupting the ZnO crystal growth process.

Cp2Mg has a structure in which magnesium metal is sandwiched by two Cp groups (cyclopentadienyl groups), and is therefore more chemically stable than TMGa, TMAI, or DMZn which are organometals having a chain hydrocarbon. As a result, Cp2Mg has a thermal decomposition temperature that is 100°C to 200°C higher than organometals having a chain hydrocarbon, and at the same time, more readily generates carbon. In other words, Cp2Mg is a metal-organic compound that has poor reactivity and that more readily results in residual carbon.

As a result of intense research, the inventor of the present invention discovered the true problem with regard to growing an MgZnO crystal using Cp2Mg. Specifically, in an MgZnO growth system in which DMZn and water vapor are used, poorly reactive Cp2Mg is added, and growth is performed in a nitrogen atmosphere (or non-reductive atmosphere), the Cp groups having a cyclic structure in the Cp2Mg do not readily react with water vapor, and cyclic and polymeric chain hydrocarbons which readily remain on the growth surface are generated. In addition, in an MgZnO crystal growth system, Cp2Mg is fed at a high flow rate due to magnesium being a crystal composition element, and this effect is therefore enhanced.

In the present invention, in light of the abovementioned knowledge relating to the process in which the magnesium-based metal-organic compound having a Cp group having a cyclic structure decomposes, the process in which Cp2Mg decomposes, which represents the abovementioned problem, is conversely utilized in an effective manner, and growth of a high-quality MgZnO crystal layer is made possible.

Specifically, in conventional methods, a reaction- disrupting hydrocarbon product is a cyclic hydrocarbon product derived from the Cp group having a cyclic structure, and the polymeric chain hydrocarbon polymerized during a ring-opening reaction is also a reaction- disrupting hydrocarbon product. These hydrocarbon products remain on the substrate surface for a long time, disrupt the MgZnO crystal growth process, generate pits (or random pits) and hillocks on the MgZnO crystal layer, and result in residual carbon.

In contrast, non-reaction-disrupting hydrocarbon products are low-molecular hydrocarbon products that have undergone a ring-opening reaction and have assumed a chain structure. These hydrocarbon products are immediately released (or desorbed) from the substrate surface and therefore do not disrupt the MgZnO crystal growth process and do not result in residual carbon.

Therefore, in the method of the present invention, high- temperature growth is performed at a growth temperature equal to or higher than the upper limit temperature for ZnO single- crystal growth, i.e., a growth temperature equal to or higher than about 850°C, whereby sufficient energy for causing the Cp group to undergo a chain- opening reaction is supplied and it is made possible for the Cp group to readily turn into a chain hydrocarbon product on the substrate surface. Also, having the growth pressure equal to or less than 5 kPa makes it possible to suppress a polymerization reaction during the chain- opening reaction and to generate a low- molecular chain hydrocarbon product.

The chain- opening reaction of the Cp group requires hydrogen element (H) for the reaction. Accordingly, water vapor is fed to the growth surface (water vapor area- flow- rate FS (H2O) : about 10 $\mu$mol·min$^{-1}$·cm$^{-2}$ or greater), thereby making it possible to accelerate generation of a low- molecular chain hydrocarbon product. At the same time, active oxygen is fed as a fragment of the above reaction to the growth surface (hereafter referred to as a "growth catalyst function"), therefore making a stable two- dimensional crystal growth (or, 2D growth) possible without a shortage of oxygen being fed, even under a high- temperature, reduced- pressure condition. As a result, it becomes possible to grow an MgZnO crystal having an excellent flatness and crystal orientation, low residual carrier concentration, and an excellent crystal quality with no residual carbon, in which formation of pits (random pits) and hillocks derived from MgZnO crystal growth is suppressed.

When DMZn and water vapor are used, and under conditions of a growth temperature equal to or greater than about 850°C and a growth pressure equal to or less than 5 kPa, growth of ZnO single-crystal is not possible. However, in the method of the present invention, the abovementioned "growth catalyst function" of Cp2Mg makes it possible to grow an MgZnO crystal having a Wurtzite structure. In other words, the method of the present invention is a crystal growth method under a unique growth condition in which even a ZnO crystal cannot be grown if Cp2Mg is not fed.

In light of the above, it can be seen that the method of the present invention is a unique method that makes it possible to remove the growth-disrupting factor in the process of thermal decomposition of a magnesium-based metal-organic compound having a Cp group under a non-reductive atmosphere, activate the growth catalyst function, and grow a high-quality MgZnO crystal. At the same time, the method can be said to be one that cannot be conceived as an extension of conventional growth methods.

[Detailed evaluation results and properties of crystal growth layer]

The evaluation results and properties and the like of crystal growth layers according to the abovementioned first through fourth embodiments and comparative examples-1 through 4 will now be described in detail with reference to the accompanying drawings. In the following description, in order to facilitate comprehension, the crystal growth layers according to the first through fourth embodiments may be referred to as EMB1 through EMB4 respectively, and the crystal growth layers of comparative examples 1 through 4 may be referred to as CMP1 through CMP4. The above crystal growth layers were evaluated and analyzed using the following methods.

The surface morphology was evaluated using a differential polarization microscope, a scanning electron microscope (SEM), and an atomic force microscope (AFM). The crystal orientation and defect/dislocation densities were evaluated using X-ray diffraction (i.e., X-ray diffractometer (XRD)). The concentration of impurities in the crystal was evaluated using secondary ion mass spectrometry (SIMS).

More specifically, in XRD measurement, it is possible to analyze and evaluate the crystal structure, crystal composition, and the state of distribution of the crystal direction (i.e., crystal orientation) . In the case of a ZnO- based single- crystal layer, the crystal composition was evaluated using a $2\theta$ measurement, and the crystal orientation was evaluated using a rocking curve measurement. More specifically, the Mg composition (x) of $Mg_xZn_{1-x}O$ was evaluated using $2\theta$ measurement of the (002)- plane, and the crystal orientation was evaluated from the half- width (full width at half maximum: FWHM) in a rocking curve measurement of the (002)- plane and the (100)- plane. If the half width is large, the amount of disruption in the orientation is large and the defect density and the dislocation density are high, and if the half width is small, the amount of disruption in the orientation is small and the defect density and/or the dislocation density are low.

In a SIMS measurement, the concentration of trace impurities contained in the crystal can be analyzed and evaluated. In particularly, in a depth-direction measurement (i.e., depth profile measurement), it is possible to obtain an impurity concentration profile along the depth direction from the surface of the crystal.

In CV measurement, the carrier concentration in the crystal can be measured and evaluated. A reverse bias voltage V is applied to a Schottky junction and the capacity C is measured. Since the tilt of $V-1/C^2$ is a function of the impurity concentration at the edge of the space charge layer, it is possible to obtain the impurity concentration (see Handotai Book (2nd edition), Ohm-sha, Ltd., page 265).

<1. Growth layer of first embodiment: EMB1>

As described above, the first embodiment is an example in which the MgZnO crystal layers 12 were grown at 850°C, 863°C, 875°C, 888°C, and 900°C, which are growth temperatures Tg for which the possibility of application is high. In particular, a feature of the method of the present invention is that the Mg composition (x) of $Mg_xZn_{1-x}O$ ($0 < x \leq 0.68$) can be adjusted with only the growth temperature Tg while maintaining a constant growth rate and water vapor flow rate. In the following description, the crystal composition of magnesium in a grown $Mg_xZn_{1-x}O$ crystal layer may be represented as Xs (=x).

(i) Surface morphology

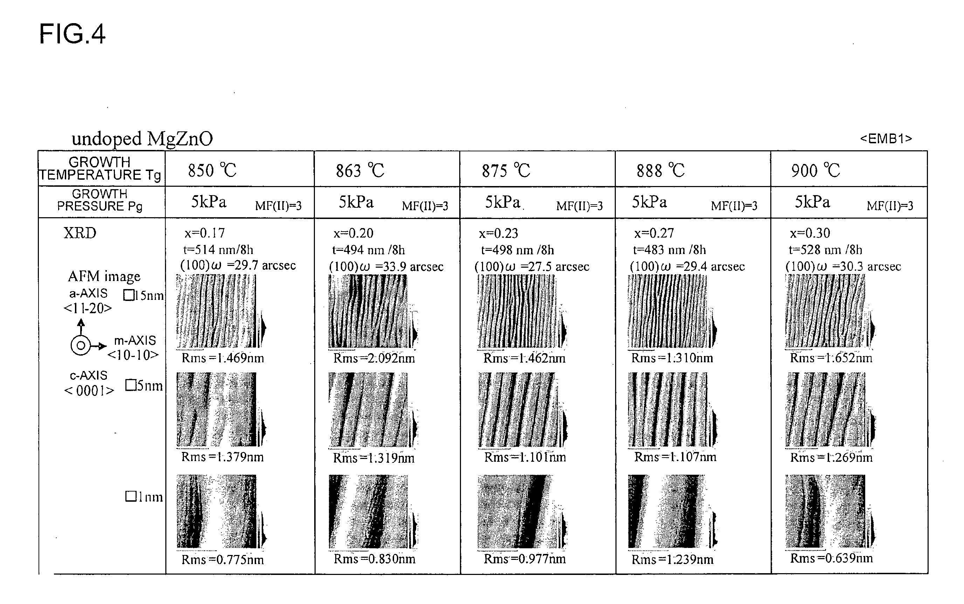

FIG. 4 shows an AFM image of each of the MgZnO growth layers according to the first embodiment. The AFM images were measured at a visual field of 15 nm per side, 5 nm per side, and 1 nm per side. The only surface morphology of the MgZnO crystal layer that was observed was vertical stripes comprising terraces and steps derived from the c-plane ZnO substrate inclined by 0.5° to the m-axis direction. The flatness is at a satisfactory level at 2 nm or less in a 15-nm square visual field. No pits (random pits) or hillocks derived from MgZnO crystal growth were observed whatsoever.

In other words, it can be seen that the method of the present invention can prevent disruptions to vertical stripes comprising terraces and steps caused by strain-relaxing stress and suppress formation of pits (random pits) and hillocks even though the Mg composition (Xs (=x)) is equal to or greater than 0.17 and the film thickness is approximately 500 nm.

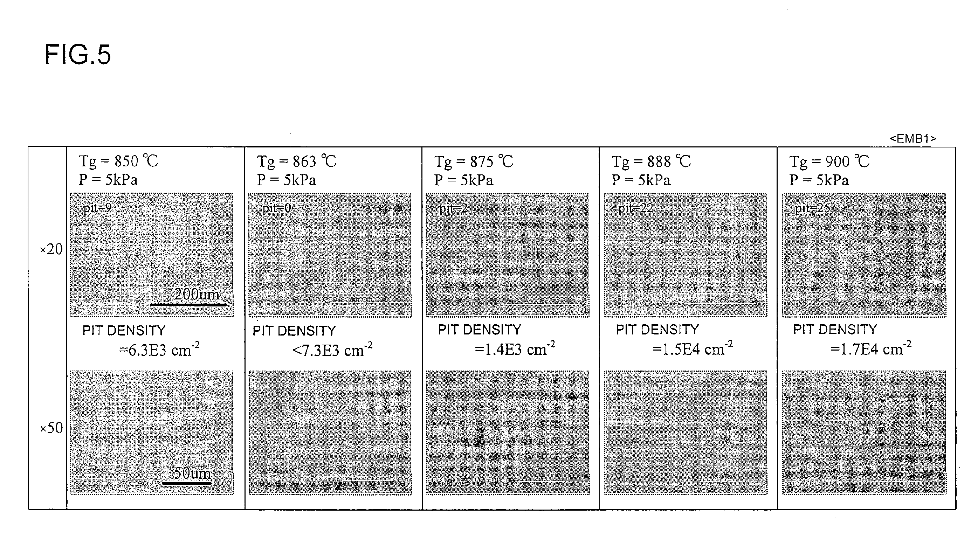

FIG. 5 shows differential interference microscopy images of each of the MgZnO growth layers according to the first embodiment. Using images having an observation magnification of 20, pits (i.e., large pits) derived from substrate defects were measured. At growth temperatures of 850°C, 863°C, 875°C, 888°C, and 900°C, the large pit densities were $6.3 \times 10^3$, less than $7.0 \times 10^3$, $1.4 \times 10^3$, $1.5 \times 10^4$, and $1.7 \times 10^4$ cm$^{-2}$, and were at a low level of about $10^3$ to $10^4$ cm$^{-2}$. Pits (i.e., large pits) derived from substrate defects are a phenomenon in which pits, originating from defects and dislocations hidden in the ZnO substrate, are generated on the MgZnO crystal layer grown thereon. In other words, although no pits are generated on the ZnO crystal layer grown on the substrate, if defects or dislocations are inherited, pits may be generated on the MgZnO crystal layer grown thereon. Such instances are also referred to as pits (i.e., large pits) derived from the ZnO substrate. Thus, it was found that formation of large pits on the growth interface of the MgZnO crystal layer can be suppressed. In the drawing, "En" represents an exponent; for example, 6.3E3 represents $6.3 \times 10^3$.

(ii) XRD

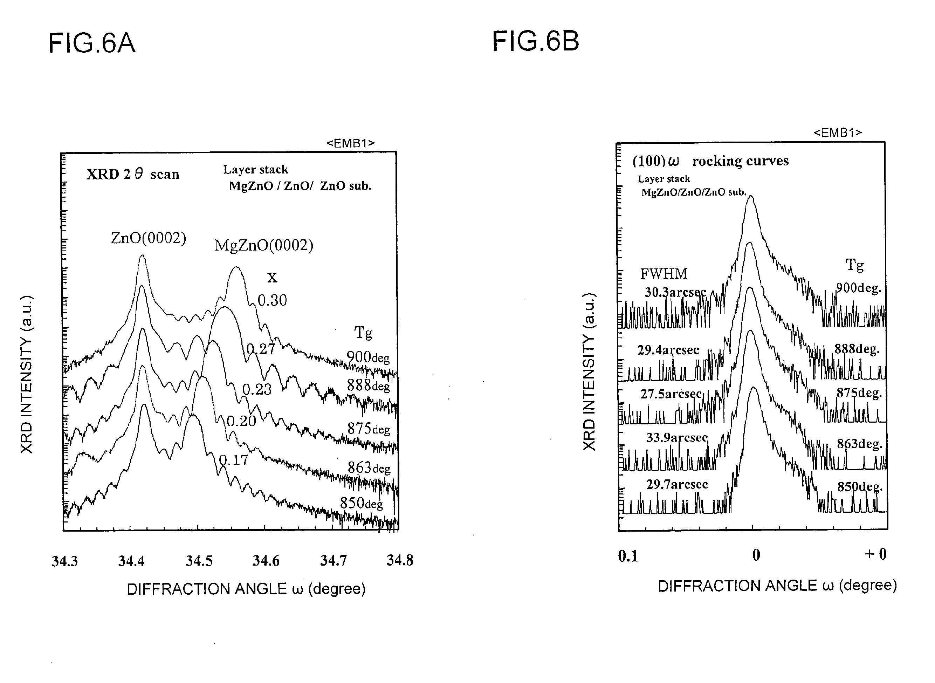

FIG. 6A shows 2θ diffraction curves of the (0002)-plane. Diffraction peaks of the MgZnO (0002)-plane are observed at higher angle side than diffraction peaks of the ZnO (0002)-plane. As the growth temperature increases, the diffraction peaks proportionally shifts towards angle side. All diffraction curves showed a good match with results of a simulation for an MgZnO/ZnO layered structure.

If, in a structure in which an MgZnO crystal layer is used as the barrier layer of a double-hetero structure such as a light-emitting diode (LED) and a ZnO crystal layer is used as the light-emitting layer, there is a disruption to the crystal layer interface, the carrier-confinement effect for the light-emitting layer will decrease and the light-emitting efficiency will decrease. Accordingly, formation of a sharp or abrupt interface is important information of a semiconductor element. According to the present invention, it is possible to grow an MgZnO crystal layer having a uniform in-plane distribution and thickness-direction distribution of magnesium. It was also found that an abrupt interface can be formed without there being a disruption to the interface between the base or underlying ZnO crystal layer and the MgZnO crystal layer.

FIG. 6B shows rocking curves of the (100)-plane of the MgZnO crystal layers. The half-widths (FWHMs) of the rocking curves are about 30 arcsecs in all temperature regions, and equivalent to the half-width of a ZnO substrate. Therefore, it was found that according to the present invention, twisting and tilting can be suppressed to extremely low levels and an MgZnO crystal layer having a good crystal orientation can be grown, even if the Mg composition (x) is equal to or greater than 0.17 and the layer thickness is approximately 500 nm.

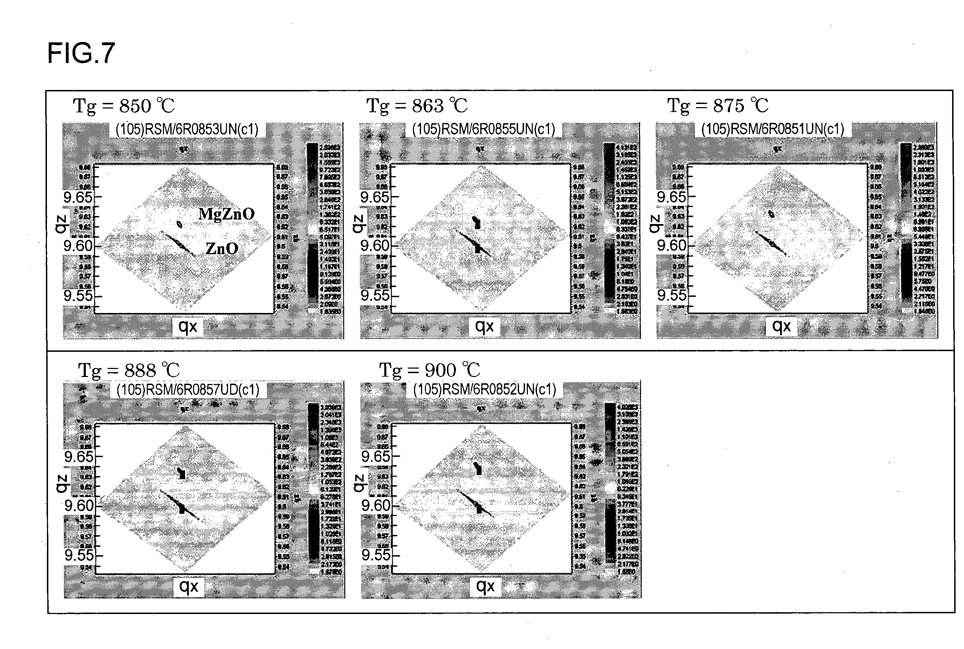

FIG. 7 shows reciprocal lattice mappings of the (105)-plane. The horizontal axis represents the m-axis direction, and the vertical axis represents the c-axis direction. In all growth temperatures, the MgZnO crystal layers are layered so that the a-axis lengths are equivalent to those of a ZnO crystal layer, and the c-axis lengths increase.

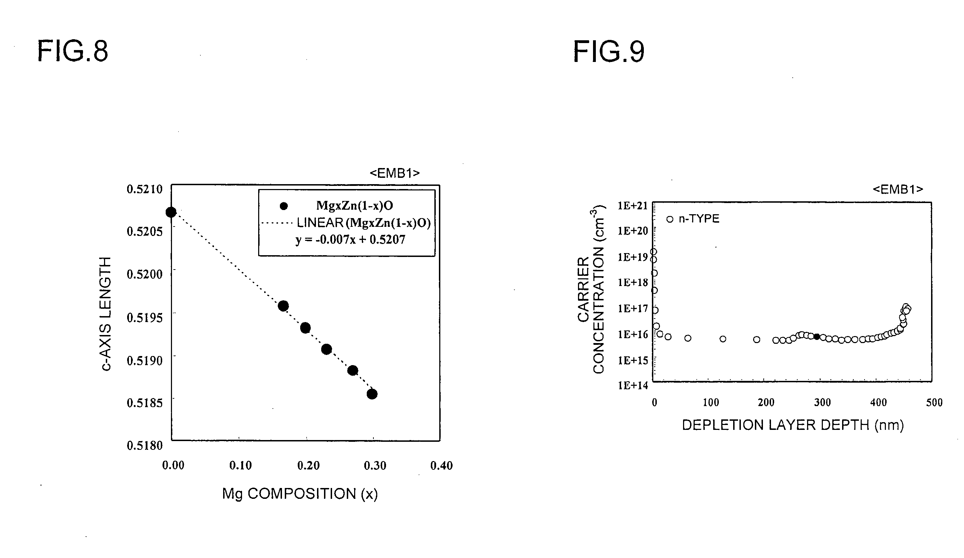

FIG. 8 shows the relationship between the Mg composition and the c-axis length. As the Mg composition (x) increases, the c-axis length decreases in a linear fashion (i.e., longer than that of a free-standing state). It was found that even if the Mg composition (x) is equal to or greater than 0.17 and the film thickness is approximately 500 nm, an MgZnO crystal layer can be grown on the ZnO crystal layer without there being any lattice relaxation.

FIG. 9 shows the carrier concentration along the depth direction, obtained by CV measurement. It was found that the residual carrier concentration of the MgZnO crystal layer grown at a growth temperature of 850°C to 900°C can be kept to an extremely low value of $4.7 \times 10^{15}$ cm$^{-3}$ to $1.3 \times 10^{16}$ cm$^{-3}$ or less. For example, if an LED is to be manufactured, it is important that the residual carrier concentration is low for forming any of an n-type semiconductor layer, a light-emitting layer, or a p-type semiconductor layer. This is because it enables formation of a semiconductor layer having an n-type carrier concentration and p-type carrier concentration proportional to the doping concentration, and makes it possible, in the light-emitting layer, to suppress unintended radiative and non-radiative transitions caused by impurity levels and improve emission efficiency.

According to the present invention, even if the growth temperature is equal to or greater than 850°C and the growth pressure is equal to or less than 5 kPa, supplying water vapor at a water vapor area-flow-rate FS (H2O) of 18.1 $\mu$mol·min$^{-1}$·cm$^{-2}$ makes it possible to utilize the effect of the growth catalyst function of Cp2Mg, suppress oxygen vacancy, and keep the residual carrier concentration to $5 \times 10^{15}$ cm$^{-3}$ or less.

(iii) SIMS

Although a description of the measurement data will not be provided, it was found that even when the Mg composition (Xs=x) was equal to or greater than 0.17, the carbon concentration was consistently equal to or less than the lower limit of detection according to SIMS measurement. It was found that according to the present invention, the Cp group can be desorbed as a low-molecular chain hydrocarbon from Cp2Mg, and since the standalone carbon can be desorbed as carbon dioxide due to the growth catalyst function, carbon intake during the growth process can be suppressed.

(iv) Mg composition and growth rate

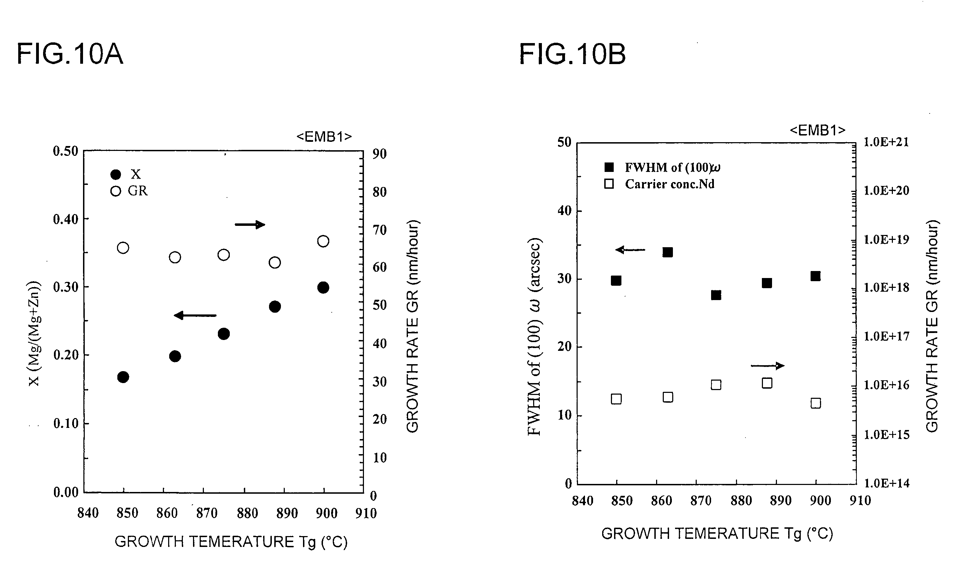

FIG. 10A shows the relationship between the Mg composition (x) and the growth rate (GR) with respect to the growth temperature. It can be seen that there is a linearly proportional relationship between the growth temperature and the Mg composition (x), and that the Mg composition can be precisely adjusted using the growth temperature (the tilt is 0.0027°C$^{-1}$) . The growth rate was substantially constant (approximately 60 to 66 nm/ hour) irrespective of the growth temperature Tg. Accordingly, when an MgZnO crystal having a different Mg composition (x) is layered, it is possible to control the composition (x) by changing the growth temperature Tg.

(v) Half-width of rocking curve and carrier density

FIG. 10B shows the relationship between the half-width FWHM of the (100) rocking curve and the carrier concentration with respect to the growth temperature. It was found that that in all growth temperature ranges, the half-width of the (100) rocking curve is constant at about 30 arcsecs, and the residual carrier density is consistently low at $2 \times 10^{16}$ cm$^{-3}$ or less.

As described above, it was confirmed that the present invention is an excellent crystal growth method that makes it possible to grow an MgZnO crystal having an excellent flatness and crystal orientation, no residual carbon, and low residual carrier concentration, in which formation of pits (large pits) derived from the ZnO substrate and pits (random pits) and hillocks derived from MgZnO crystal growth is suppressed.

According to the present invention, it is possible to form an MgZnO crystal layer in which the Mg composition necessary for the barrier layer of the MgZnO-based semiconductor light-emitting element is no less than 0.1, the film thickness is equal to or greater than approximately 30 nm, and the a-axis length is coherent with respect to the a-axis length of a ZnO crystal. It was confirmed that the crystal formation is possible for an Mg composition (x) of up to at least 0.375 and a film thickness of up to approximately 500 nm.

<2. Growth layer of second embodiment: EMB2>

As described above, in the second embodiment, the MgZnO crystal layers were grown at growth temperatures Tg of 775°C, 825°C, 875°C, and 925°C.

(i) Surface morphology

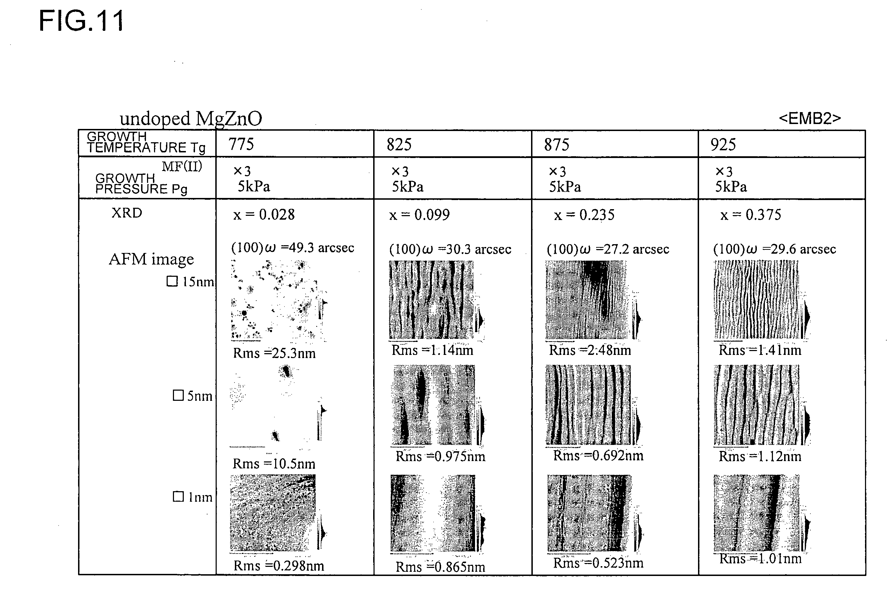

FIG. 11 shows AFM images of the MgZnO growth layers. For the instance in which the growth temperature Tg is 775°C, film vacancy defects (i.e., vacant portions or pores in the film) are present, and there is a disruption to the vertical stripe pattern (i.e., terraces and steps) derived from the c-plane ZnO substrate offset towards the m-axis direction. Some of the disruption remains at a growth temperature of 825°C. In contrast, it was found that high-quality MgZnO single-crystal layers can be grown, as with the case of the first embodiment, at growth temperatures Tg of 875°C, and 925°C.

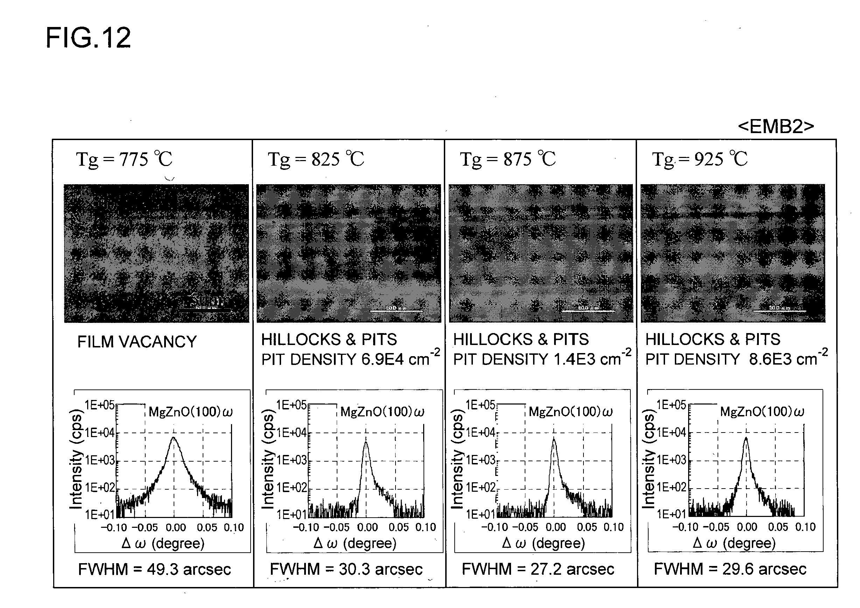

FIG. 12 shows (100)- plane rocking curves and differential- interference microscope images of the MgZnO crystal layers for every growth temperature. As shown in the differential- interference microscope images, the large- pit density derived from substrate defects was measured at an observation magnification of 50. The large- pit density at 775°C, 825°C, 875°C, and 925°C was countless (i.e. film vacancy defects), $6.9 \times 10^4$ cm$^{-2}$, $1.4 \times 10^3$ cm$^{-2}$, and $8.6 \times 10^3$ cm$^{-2}$ respectively. The large pit density decreases for growth temperatures equal to or greater than 875°C.

(ii) XRD

As shown in the (100)- plane rocking curves in FIG. 12, the half- width of the rocking curves was large at 49.3 arcsecs at a growth temperature of 775°C. At a growth temperature equal to or greater than 825°C, the half width decreases to 30 arcsecs, and the crystal orientation improves.

In light of the above results, the effective growth temperature is from excess of 825°C, and taking the results of the first embodiment into consideration, about 850°C or above is the preferred growth temperature. On the high-temperature side, an excellent crystal quality is maintained even at 925°C (i.e., Mg composition (x) = 0.375), and crystal growth remains possible at regions of even higher temperatures. The upper limit is not known, but is thought to be about 1000°C to 1100°C. Taking the heater facility costs and heater lifespan into consideration, an upper limit of about 1100°C is appropriate.

In contrast, at 775°C, which is a suitable temperature range for ZnO crystal growth, a film vacancy defect was generated. This is thought to be because in a suitable temperature range for ZnO crystal growth, even if the growth pressure is 5 kPa, a thermal decomposition product of Cp2Mg is a cyclic hydrocarbon and disrupts growth.

In light of the growth results at 825°C and 850°C, the Mg composition (x) is preferably equal to or greater than 0.1, and further preferably equal to or greater than 0.17. This is because the growth catalyst function of Cp2Mg becomes effective and the MgZnO crystal grows in a stable manner.

<3. Growth layer in third embodiment: EMB3>

As described above, in the third embodiment, MgZnO crystal layers were grown at growth pressures Pg of 2 kPa, 5 kPa, 10 kPa, 20 kPa, and 40 kPa.

(i) Surface morphology

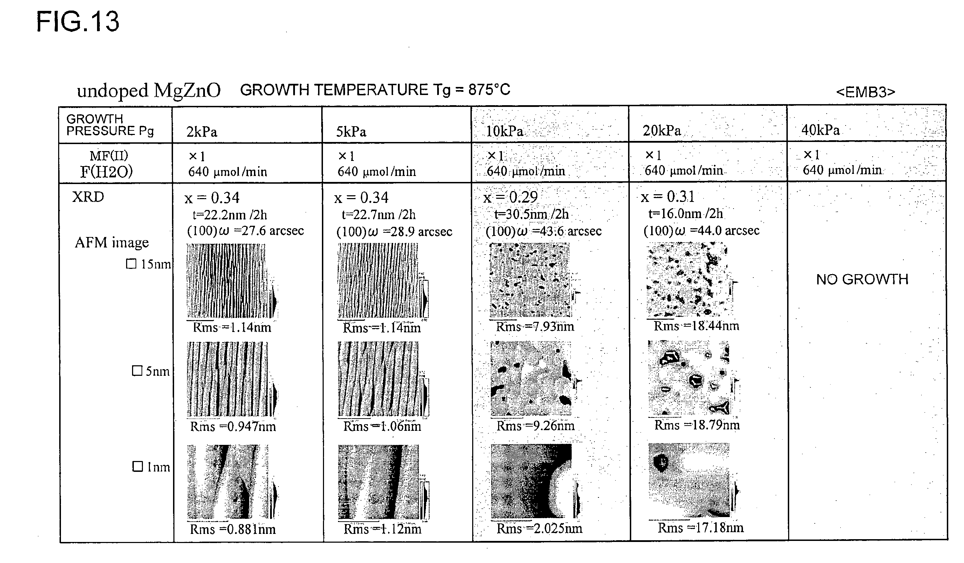

FIG. 13 shows AFM images of the growth layers. When the growth pressure Pg is 2 kPa or 5 kPa, a vertical stripe pattern derived from the c-plane ZnO substrate is observed, and no pits (random pits) or hillocks derived from the MgZnO crystal growth process are observed. However, when the growth pressure Pg is 10 kPa or 20 kPa, a film vacancy defect is generated, and film formation becomes impossible at 40 kPa.

(ii) XRD

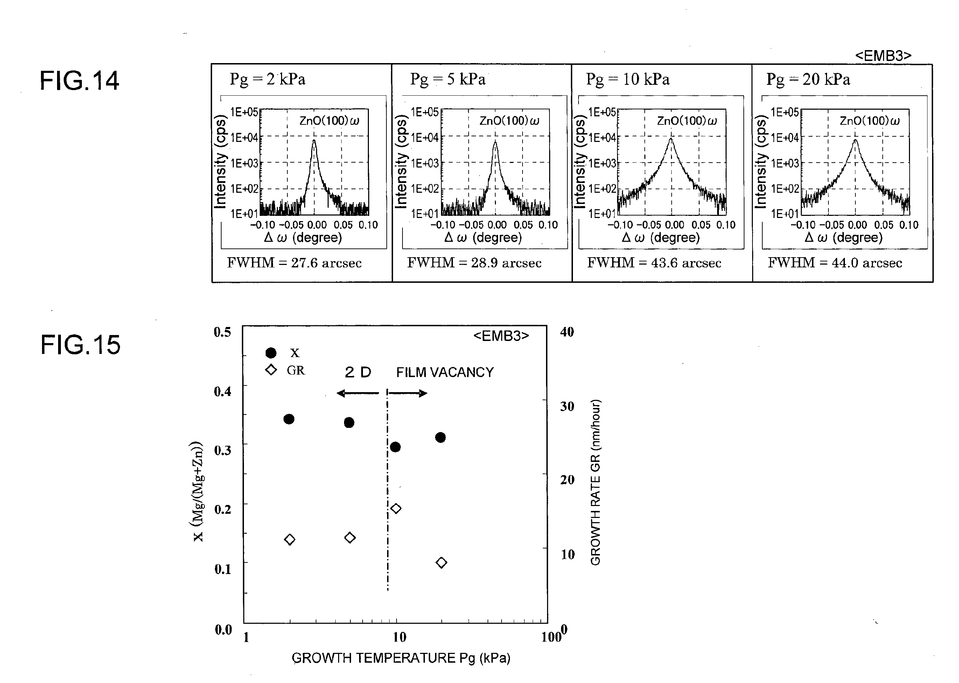

FIG. 14 shows (100)- plane rocking curves of the MgZnO growth layers. For growth pressures Pg of 2 kPa and 5 kPa, the half- widths of the rocking curves are 27.6 arcsecs and 28.9 arcsecs respectively, indicating that MgZnO single- crystal layers having an excellent orientation were formed. In contrast, at 10 kPa and 20 kPa, the half- widths are larger at 43.6 arcsecs and 44.0 arcsecs, showing that crystal orientation has degraded.

(iii) Mg composition and growth rate

FIG. 15 shows the relationship between the growth pressure (Pg) and the Mg composition (x) and between the growth pressure (Pg) and the growth rate (GR). At about 5 kPa or less at which satisfactory crystal growth is observed, the Mg composition and the growth rate are not dependent on the growth pressure.

In light of the above results, the effective growth pressure is less than 10 kPa, and is preferably no more than about 5 kPa. If the amount of water vapor fed is sufficient, the growth catalyst function of the Cp2Mg is effective, so a high-quality MgZnO single-crystal can be grown even at 2 kPa. Crystal growth is possible at even lower pressures. Taking the depressurization facility cost into consideration, an appropriate lower limit is about 0.5 kPa.

In contrast, if the MgZnO crystal growth pressure is 10 kPa, a film vacancy defect is generated. Specifically, if the growth pressure is 10 kPa, a thermal decomposition product of Cp2Mg is a cyclic hydrocarbon and disrupts growth, even of the growth temperature is 875°C.

<4. Growth layer in fourth embodiment: EMB4>

As described above, in the fourth embodiment, growth was performed for four instances between which the flow rate of group II (DMZn, Cp2Mg) is different. More specifically, based on an instance in which (F (DMZn), F (Cp2Mg)) = (10 $\mu$mol/min, 0.334 $\mu$mol/min) (i.e., MF (II) of group- II flow rate: $\times$ 1), growth was performed in instances in which the flow rate is twofold, threefold, and fourfold larger than the above flow rate (i.e., MF (II) : $\times$2, $\times$3, $\times$4), respectively.

(i) Surface morphology

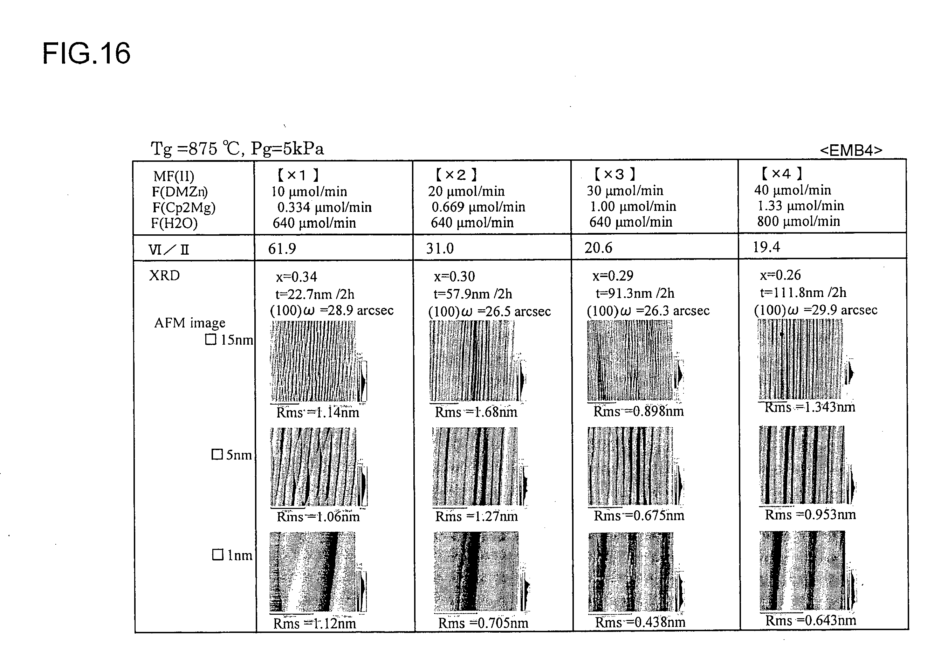

FIG. 16 shows AFM images of the growth layers. A vertical stripe pattern derived from the c-plane ZnO substrate is observed across the range in which the group-II flow rate magnification MF(II) is onefold to fourfold ($\times$1 to $\times$4). No

pits (random pits) derived from MgZnO crystal growth are observed.

(ii)

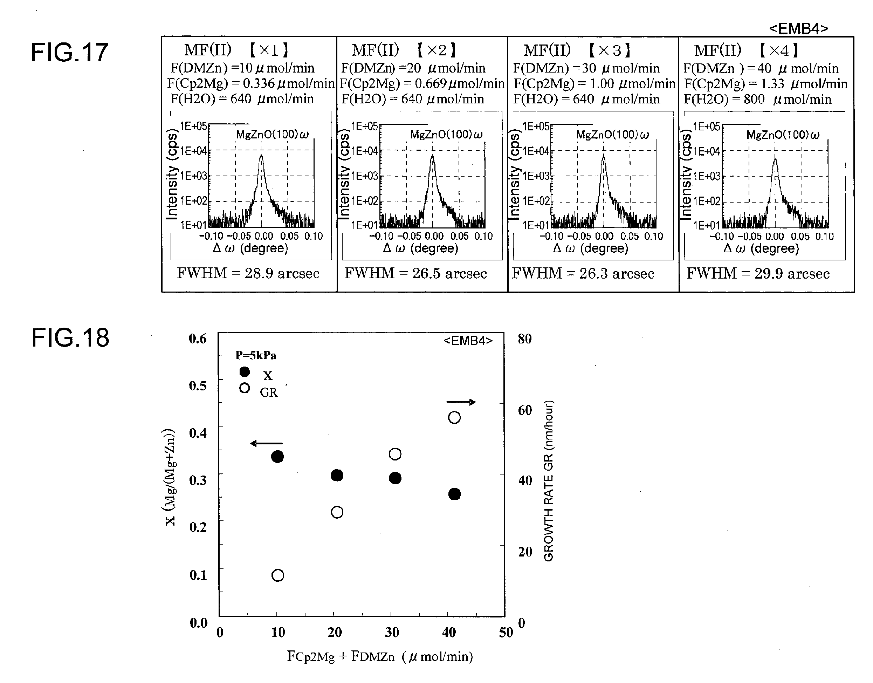

FIG. 17 shows (100)- plane rocking curves of the MgZnO growth layers. The half- widths FWHM of the rocking curves are all small at about 30 arcsecs in the range of the group- II flow rate, indicating that MgZnO single- crystal layers having an excellent crystal orientation are formed.

(iii) Mg composition and growth rate

FIG. 18 shows the relationship between the group II flow rate and the Mg composition (x) and between the group II flow rate and the growth rate (GR). With an increase in the group-II flow rate, the Mg composition (x) decreases slightly from 0.34 to 0.26. The growth rate increases in proportion to the increase in the flow rate from 11.3 nm/hour to 56 nm/hour.

The decrease in the Mg composition (x) is considered to be caused by an increase in the Cp2Mg flow rate accompanying the increase in the group- II flow rate causing an increase in the reaction catalyst function, an increase in the amount of oxygen fed to the growth surface, and an increase in the ZnO crystal component. Specifically, it can be seen that provided that the water vapor area- flow- rate FS (H2O) is 14.5 $\mu$mol·min$^{-1}$·cm$^{-2}$ or 18.1 $\mu$mol·min$^{-1}$·cm$^{-2}$, then an adequate level will be achieved even if the group- II flow rate is increased up to fourfold.

(iv) Method of defining relationship between VI/II ratio and water vapor flow rate

In the fourth embodiment, if the group-II flow rate is in the onefold to threefold ($\times$1 to $\times$3) range, the water vapor flow rate is constant at 640 $\mu$mol/min. Therefore, with an increase in the group-II flow rate, the VI/II ratio decreases from 61.9 to 31.0 and then 20.6. Here, even though the VI/II ratio is lowered, the Mg composition (x) decreases from 0.34 to 0.30 and then 0.29. For example, in the method according to Patent Document 1, the water vapor flow rate is reduced to increase the Mg composition. In other words, the VI/II ratio is lowered to increase the Mg composition; whereas in the present invention, the characteristics are opposite (i.e., the Mg composition (x) decreases).

In light of the above results, if the water vapor area- flow- rate FS (H2O) is 14.5 $\mu$mol·min$^{-1}$·cm$^{-2}$ and 18.1$\mu$mol·min$^{-1}$·cm$^{-2}$, an MgZnO single- crystal layer having an excellent crystal quality can be grown even if the group-II flow rate is increased up to fourfold. A further increase in the group- II flow rate is thought to be possible.

The group- II flow rate (i.e., the molar flow rate per unit time ($\mu$mol·min$^{-1}$) ) must not exceed the water vapor flow rate (i.e., the molar flow rate per unit time ($\mu$mol·min$^{-1}$) ) .

The lower limit of the water vapor area- flow- rate is considered to be roughly 10 $\mu$mol·min$^{-1}$·cm$^{-2}$. Similarly, taking the water vapor supply facility cost into account, about 54 $\mu$mol·min$^{-1}$·cm$^{-2}$ is appropriate for the upper limit. The water vapor saturation rate at room temperature is 30% for 18.1, so the maximum limit at which water vapor can be fed, which is 90%, is equivalent to 54 $\mu$mol·min$^{-1}$·cm$^{-2}$.

According to the method of the present invention, although an increase or decrease in the group-II flow rate causes a slight decrease or increase in the Mg composition, the crystal quality of the MgZnO crystal layer is unaffected.

<5. Growth layer in comparative example-1: CMP1>

In comparative example-1, for the sake of comparison with the growth method of the present invention, the growth temperature was 775°C, which is an appropriate conventional growth temperature for a ZnO crystal. The growth is performed according to a method in which the growth pressure is reduced (pressure Pg: 10 kPa) and the water vapor flow rate is low, and unnecessary reaction with the magnesium-based metal-organic compound is minimized (e.g., see Patent Document 1). The growth conditions for comparative example-1 are shown together in Table 1.

Table 1: Growth conditions (comparative example-1)

| Water vapor flow rate ($\mu$mol·min$^{-1}$) | 40 | 80 | 160 | 320 | 640 |
|---|---|---|---|---|---|
| VI/II ratio | 3.8 | 7.6 | 15.2 | 30.3 | 60.6 |
| Mg composition (x) | 0.32 | 0.26 | 0.16 | 0.14 | 0.11 |
| Grown layer thickness (nm) | 60 | 85 | 138 | 142 | 240 |

(i)Surface morphology

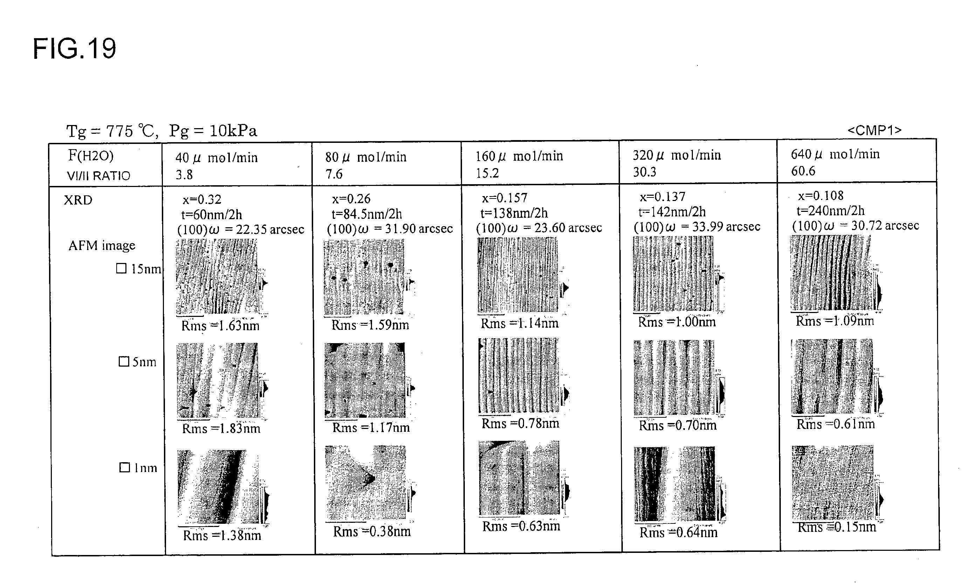

FIG. 19 shows AFM images of growth layers according to comparative example-1. In the AFM images, vertical stripes comprising terraces and steps derived from the 0.5°-off c-plane ZnO substrate were observed, but pits (random pits) derived from the MgZnO crystal growth and pits (large pits) derived from substrate defects were observed at high densities. As an exception, no pits were observed in the AFM visual field for the water vapor flow rate of 640 $\mu$mol/min.

In the method for growing an MgZnO crystal at a growth temperature in which a ZnO single-crystal can be grown, hydrocarbons that disrupt the process of MgZnO crystal growth are generated during thermal decomposition of Cp2Mg; therefore, there is a tendency for the density of pits derived from MgZnO crystal growth (i.e., random pits) to increase. In addition, since the growth process is disrupted and unstable, the density of occurrence of random pits tends to vary between each crystal growth.

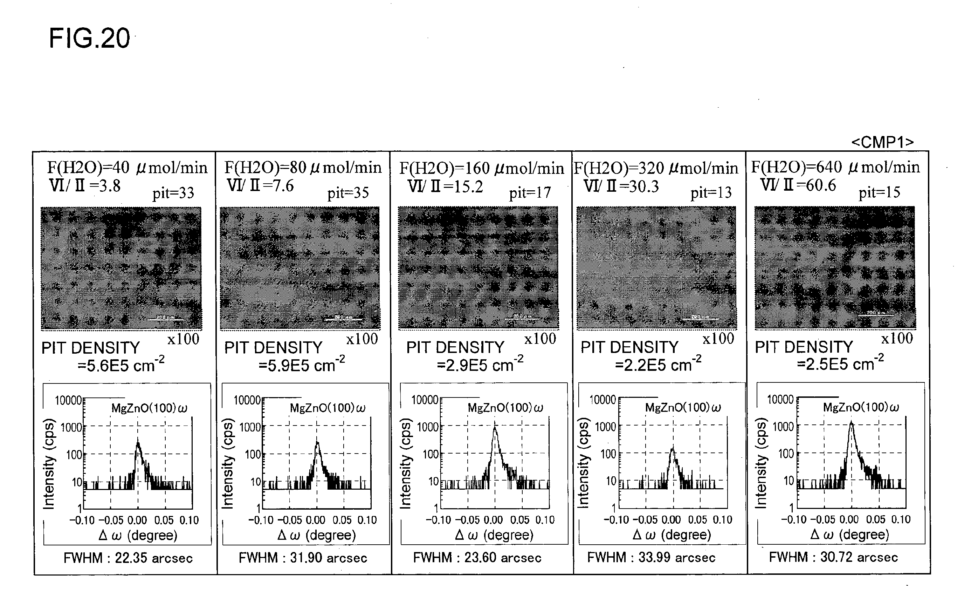

FIG. 20 shows (100)- plane rocking curves and differential- interference microscope images of the growth layers. For the differential- interference microscope images, the density of pits (large pits) derived from substrate defects was measured using images having an observation magnification of 100. The large- pit densities were $5.6 \times 10^5$, $5.9 \times 10^5$, $2.9 \times 10^5$, $2.2 \times 10^5$, and $2.5 \times 10^5$ cm$^{-2}$ for water vapor flow rates of 40, 80, 160, 320, and 640 $\mu$mol/min, respectively.

According to the conventional MgZnO crystal growth method, the density of pits (large pits) derived from substrate defects is relatively high; i.e., on the order of the fifth power ($10^5$). This is thought to be because due to a combination of growth disruption and properties of the MgZnO crystal containing a distortion, pits are formed during the stage of MgZnO crystal growth so as to originate from the types of defects and dislocations that do not result in formation of pits in the underlying ZnO crystal layer (or grown layer).

(ii) XRD

As shown in FIG. 20, the half-widths of the rocking curves are about 30 arcsecs in all water vapor flow rate regions, and the crystal orientation was at a satisfactory level.

In the method for growing an MgZnO crystal, the pressure and the water vapor flow rate are reduced to suppress unnecessary reaction with the magnesium-based metal-organic compound in order to increase the quality of the MgZnO crystal layer. However, pits derived from the MgZnO growth process (i.e., random pits) cannot be suppressed in a stable manner. Furthermore, the densities of pits derived from substrate defects (i.e., large pits) are in the order of the fifth power, which is higher than those according to the above embodiments.

With the increase in the water vapor flow rate, as the VI/II ratio increases, the Mg composition (x) decreases. More specifically, as the VI/II ratio increases from 3.8 to 60.6, the Mg composition (x) falls dramatically from 0.32 to 0.108. Additionally, the growth rate increases as the VI/II ratio increases.

<6. Growth layer in comparative example-2: CMP2>

In comparative example-2, the MgZnO crystals were grown at different growth temperatures Tg. The growth pressure Pg was 10 kPa, the flow rate of DMZn was 10 $\mu$mol/min, and the flow rate of Cp2Mg was 0.556 $\mu$mol/min (or 0.334 $\mu$mol/min). A water vapor flow rate of 640 $\mu$mol/min, at which no random pits were observed in the first embodiment, was used. The growth conditions for comparative example-2 are shown together in Table 2.

[Table 2]

Table 2: Growth conditions (comparative example-2)

| Growth temperature Tg (°C) | 700 | 750 | 775 | 800 | 825 | 850 |
|---|---|---|---|---|---|---|
| Mg composition (x) | 0.04 | 0.05 | 0.11 | 0.16 | 0.19 | 0.25 |
| Grown layer thickness (mm) | 599 | 386 | 240 | 119 | 57 | 26 |

(i) Surface morphology

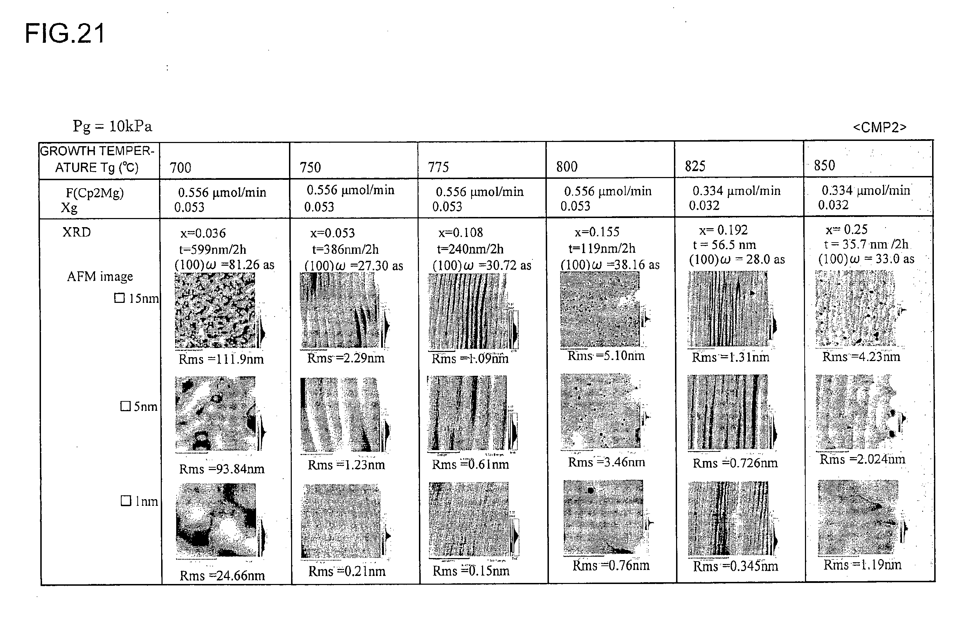

FIG. 21 shows AFM images of the growth layers. At a growth temperature of 700°C, 3-dimensional growth (3D growth) occurs, and at 750°C or above, vertical stripes comprising terraces and steps derived from the 0.5°-offset c-plane ZnO substrate were observed. At growth temperatures of 750°C and 775°C, pits (random pits) derived from MgZnO crystal growth were not observed. However, at growth temperatures of 800°C and 825°C, the random pit density increased. At an even higher temperature of 850°C, film vacancy defects were generated.

The low random pit density at low temperatures is considered to be because the ZnO crystal component being more readily grown causes a corresponding reduction in the effect of the thermal decomposition product of Cp2Mg or a decrease in the amount of the thermal decomposition product itself. The reduction in the growth layer thickness and the increase in the Mg composition at higher temperatures are considered to be due to the growth of the ZnO crystal component becoming more difficult.

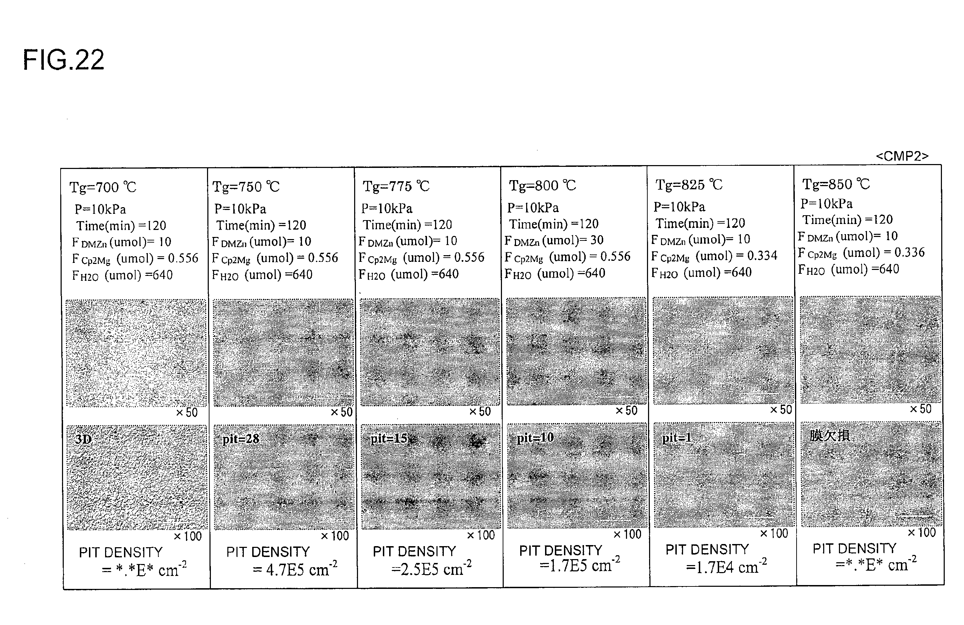

FIG. 22 shows differential-interference microscope images of the growth layers. The density of pits (large pits) derived from substrate defects was measured using images having an observation magnification of 100. The large pit densities were, for growth temperatures of 700, 750, 775, 800, 825, and 850°C, impossible to measure due to 3-dimensional growth, $4.7 \times 10^5$, $2.5 \times 10^5$, $1.7 \times 10^5$, $1.7 \times 10^4$ cm$^{-2}$, and impossible to measure due to film vacancy defects, respectively. With the exception of growth temperatures of 700°C and 850°C, there is a tendency for the large pit density to be higher at lower temperatures and lower at higher temperatures. This is thought to be caused by the fact that at lower temperatures, migration of growth species during the 2-dimensional crystal growth (2D growth) process decreases, and at higher temperatures, migration of growth species in the 2-dimensional crystal growth process improves.

(ii) XRD

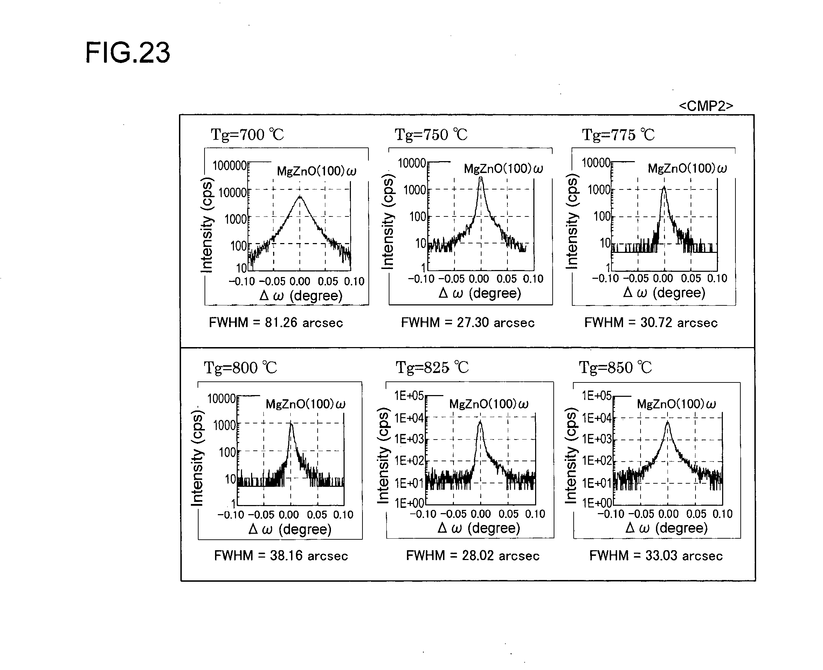

FIG. 23 shows the (100)- plane rocking curves of the MgZnO crystal layers. The half- width FWHM of the rocking curve for a growth temperature Tg of 700, 750, 775, 800, 825, and 850°C was 81.3 arcsecs, 27.3 arcsecs with a spread at the base, 30.7 arcsecs, 38.2 arcsecs, 28.0 arcsecs, and 33.0 arcsecs with a spread at the base, respectively. The crystal orientation was at a satisfactory level when the growth temperature Tg was in a range of 775°C to 825°C.

In light of the above results, the growth temperature range according to the conventional MgZnO crystal growth method was from approximately 750°C to about 825°C. Although the data is not shown here, for a growth performed with a water vapor flow rate of 60 μmol/min, an increase in random pits and a spreading of the base of the (100)- plane rocking curve were again observed at 825°C. Accordingly, the corresponding MgZnO crystal growth method is one that can be applied to a growth temperature of 825°C or less.

<7. Growth layer in comparative example-3: CMP3>

In comparative example-3, MgZnO crystals were grown at different growth pressures Pg of 10 kPa, 20 kPa, and 40 kPa. The growth temperature was 775°C, the flow rate of DMZn was 10 μmol/min, and the flow rate of Cp2Mg was 0.556 μmol/min. A water vapor flow rate of 640 μmol/min, at which no random pits were observed in the first embodiment, was used.

(i) Surface morphology

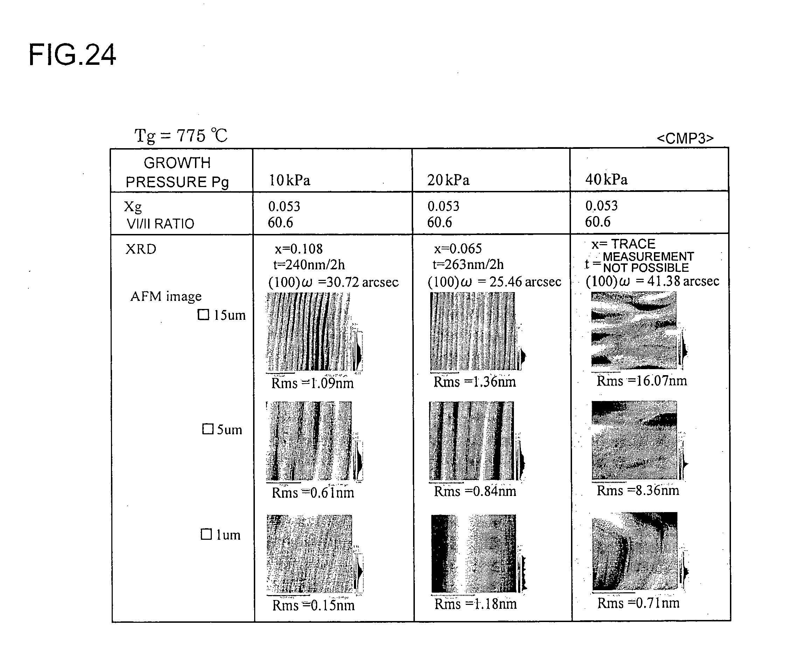

FIG. 24 shows AFM images of the growth layers. Vertical stripes comprising terraces and steps derived from the 0.5°-offset c-plane ZnO substrate were observed for growth pressures Pg of 10 kPa and 20 kPa. The morphology was indefinite at a growth pressure Pg of 40 kPa.

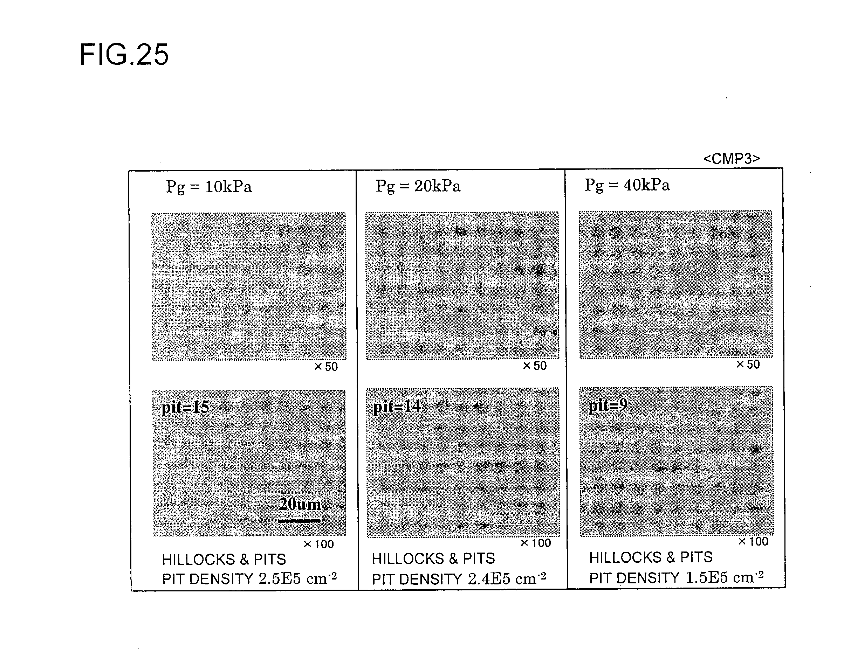

FIG. 25 shows differential-interference microscope images of the growth layers. The density of pits derived from substrate defects (i.e., large pits) were observed in the images having an observation magnification of 100. The large-pit densities were at high levels of $2.5 \times 10^5$, $2.4 \times 10^5$, and $1.5 \times 10^5$ cm$^{-2}$ for growth pressures of 10 kPa, 20 kPa, and 40 kPa, respectively. A flow-like pattern was observed on the growth surface for a growth pressure Pg of 40 kPa.

(ii) XRD

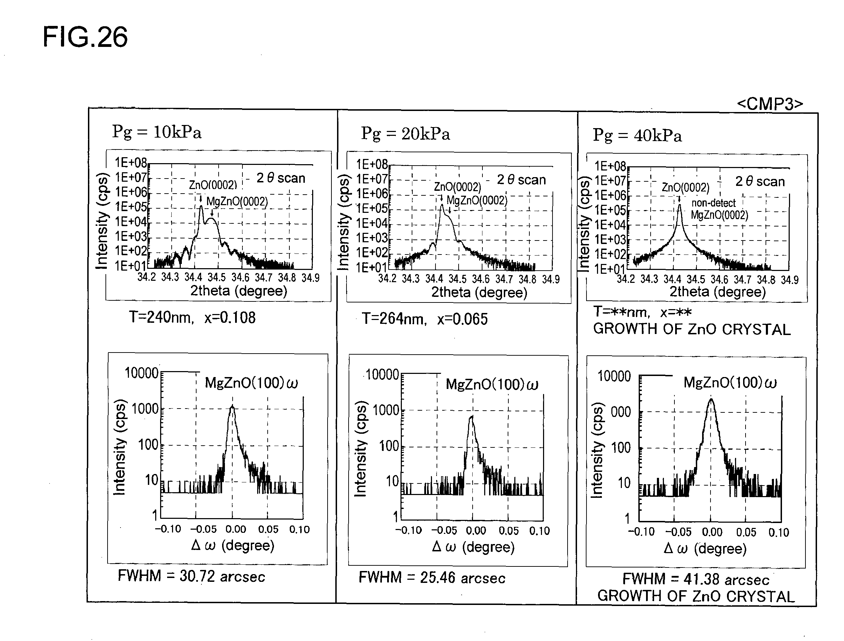

FIG. 26 shows 2θ and (100)ω rocking curves of the MgZnO crystal layers. For growth pressures of 10 kPa, 20 kPa, and 40 kPa, the Mg composition (x) was 0.108, 0.065, and 0.00, respectively; as the growth pressure Pg increases, the Mg composition (x) decreases. In particular, when the growth pressure Pg is at 40 kPa, the Mg composition (x) was substantially zero, and the crystal being grown was ZnO. The half-widths of the rocking curves were 30.7 arcsecs, 25.5 arcsecs, and 41.4 arcsecs; crystal orientation was poor for growth at 40 kPa.

According to the conventional method for growing an MgZnO crystal, the pressure and the water vapor flow rate are reduced to suppress unnecessary reaction with the magnesium-based metal-organic compound in order to increase the quality of the MgZnO crystal layer. Accordingly, when the growth pressure Pg is 40 kPa, unnecessary reaction causes growth of a ZnO crystal layer having poor crystal orientation, the effect of suppressing the unnecessary reaction starts to take hold from 20 kPa, and MgZnO crystal growth having an Mg composition of 0.108 becomes possible at 10 kPa. However, the density of pits (large pits) derived from substrate defects are at a high level, in the order of the fifth power.

According to the conventional method, the ZnO crystal layer grows up to at least about 40 kPa, although with poor crystal quality. In contrast, according to the method of the present invention, film formation is not possible when the growth pressure Pg is 40 kPa. In other words, the growth method according to the present invention differs from the conventional growth method in this respect.

<8. Growth layer in comparative example-4: CMP4>

In comparative example-4, growth was performed for three instances between which the total flow rate F (II+VI) of the material gas (DMZn, Cp2Mg, $H_2O$) differs, i.e., for instances in which the flow rate magnification MF (II+VI) is 1, 2, and 3 (i.e., $\times$ 1, $\times$ 2, and $\times$ 3). The growth conditions for comparative example-4 are shown together in Table 3.

Table 3: Growth conditions (comparative example-4)

| Total flow rate of material gas | $\times 1$ | $\times 2$ | $\times 3$ |
|---|---|---|---|
| Mg composition (x) | 0.41 | 0.30 | 0.15 |
| Grown layer thickness (mm) | 36 | 92 | 143 |

(i) Surface morphology

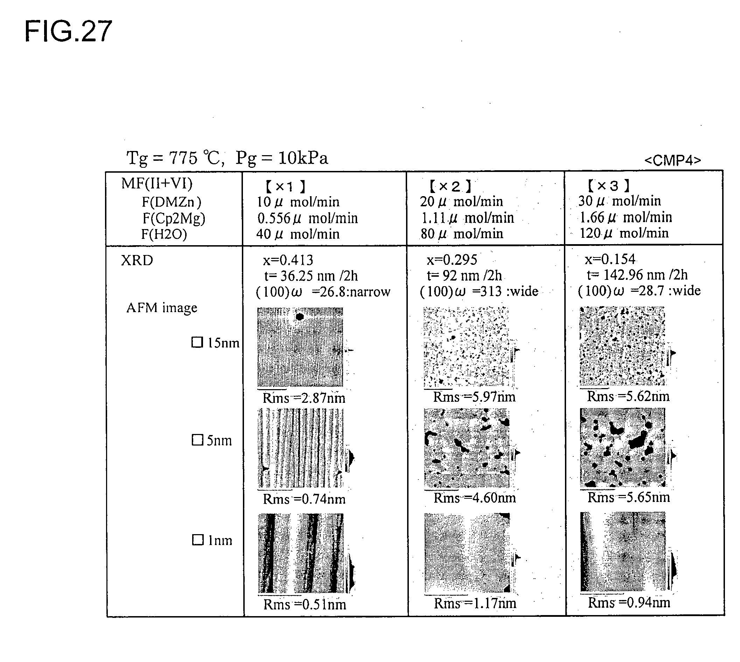

FIG. 27 shows AFM images of the growth layers. At a total flow rate of the material gas of $\times 1$, vertical stripes comprising terraces and steps derived from the 0.5°-offset c-plane  ZnO substrate were observed. At a total flow rate of the material gas of $\times 2$ and $\times 3$, the density of pits (random pits) derived from the MgZnO crystal growth was high, and a film vacancy defect was generated.

(ii) XRD

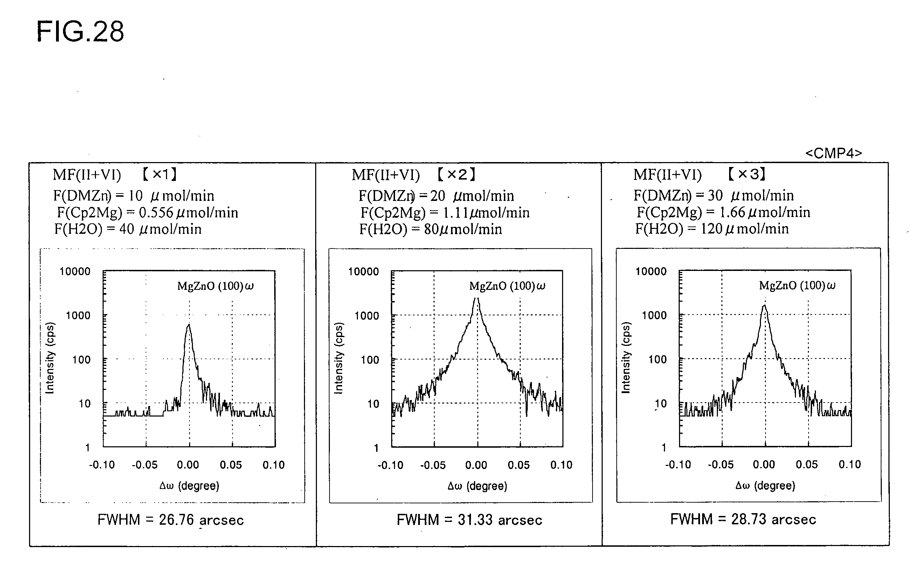

FIG. 28 shows (100)- plane rocking curves of the MgZnO crystal layers. The half- widths FWHM of the rocking curves were 26.8 arcsecs, 31.3 arcsecs (with a wide base), and 28.7 arcsecs (with a wide base) for a total material gas flow rate of $\times 1$, $\times 2$, and $\times 3$, respectively; the crystal orientation deteriorated when the material gas flow rate was increased to $\times 2$ and $\times 3$.

According to the conventional method for growing an MgZnO crystal, the pressure and the water vapor flow rate are reduced to suppress unnecessary reaction with the magnesium-based metal-organic compound in order to increase the quality of the MgZnO crystal layer. Therefore, if the total material gas flow rate is increased, it becomes no longer possible to suppress unnecessary reaction, and the MgZnO crystal layer deteriorates. The water vapor flow rate in comparative example-4 is 80 $\mu$mol/min when the total material gas flow rate is $\times 2$, and is still merely 120 $\mu$mol/min when the total material gas flow rate is $\times 3$, which are less than 640 $\mu$mol/min in comparative example-2 and comparative example-3. Therefore, it is considered that the increase in the flow rate of the metal-organic material is causing unnecessary reaction.

In contrast, according to the MgZnO crystal growth method of the present invention, as described in the fourth embodiment, even if the group-II flow rate is increased from $\times 1$ to $\times 4$, a MgZnO crystal layer can be grown to have an excellent crystal quality. In other words, the growth method according to the present invention differs from the conventional growth method in this respect.

[Growth method of the present invention]

In light of the abovementioned first through fourth embodiments according to the present invention, the growth temperature is equal to or greater than about 825°C, and is preferably equal to or greater than 850°C. The thermal decomposition product of Cp2Mg begins to be a low-molecular chain hydrocarbon at a growth temperature upward of 825°C, and the reaction stabilizes and growth of an MgZnO crystal layer having good crystallinity becomes possible at a growth temperature upward of 850°C. In particular, on the high-temperature side, growth of an MgZnO crystal took place without problem even at 925°C.

The upper limit of the growth pressure is less than 10 kPa, and preferably equal to or less than about 5 kPa. Generation of a high-molecular hydrocarbon produced by thermal decomposition of Cp2Mg can be suppressed when the growth pressure is less than 10 kPa, and a growth pressure equal to or less than about 5 kPa is suited for completely suppressing the generation of a high-molecular hydrocarbon produced by thermal decomposition of Cp2Mg and obtaining an  MgZnO crystal layer having a good crystal quality. In particular, on the low-pressure side, satisfactory growth took place even at 2 kPa, and the lower limit of the pressure is not known.

A water vapor flow rate of 10 $\mu$mol·min$^{-1}$·cm$^{-2}$ is desirable, and 15 $\mu$mol·min$^{-1}$·cm$^{-2}$ or greater is further preferred. In order to utilize the growth catalyst function of Cp2Mg in growing the MgZnO crystal layer, it is crucial that a sufficient amount of water vapor is fed to the substrate surface.

In the method of the present invention, the growth catalyst function of Cp2Mg is utilized in growing the MgZnO crystal layer; therefore, the method is not dependent on the VI/II ratio or the oxygen partial pressure. Nevertheless, the water vapor flow rate must exceed the group-II (i.e., DMZn and Cp2Mg) molar flow rate.

[Consideration of the crystal growth mechanism of the present invention]

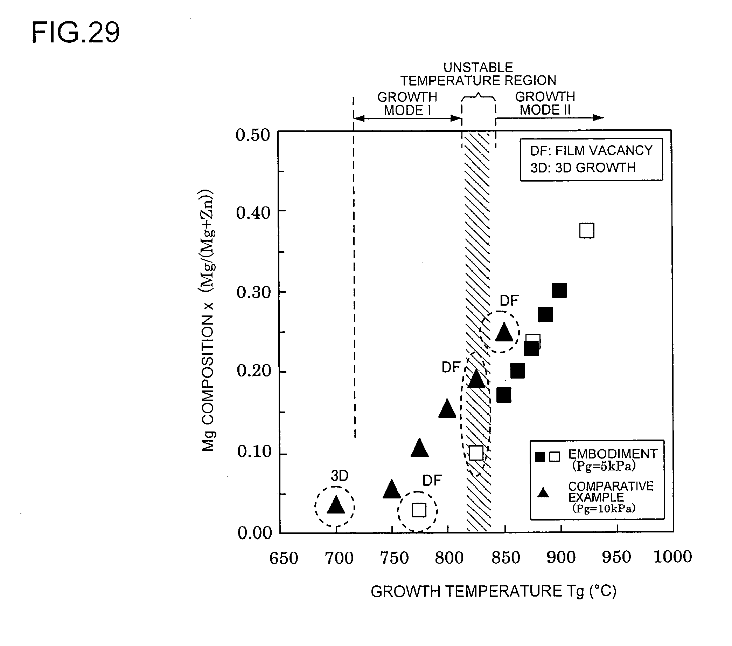

FIG. 29 shows the Mg composition (x) in relation to the growth temperature Tg in the embodiments and the comparative examples described above.

As shown in FIG. 29, conventionally, when an MgZnO or another ternary mixed crystal is grown by MOCVD, there is used a means in which, ZnO growth conditions such as the growth temperature or the growth pressure are used as base conditions, a magnesium-based metal material such as Cp2Mg is added, and the magnesium composition is increased (hereafter referred to as "growth mode I"). At temperatures lower or higher than the temperature range in which a ZnO single-crystal can be grown, the ZnO crystal undergoes a 3-dimensional (3D; indicated by dashed line in the drawing) growth or film vacancy (DF; indicated by dashed lines in the drawing) is generated. An unstable-growth temperature region at which a film vacancy defect is likely to be generated is present on the high-temperature side of the growth temperature range for the ZnO single crystal. With regard to growth in this growth temperature range, there is a method for increasing the crystal quality while suppressing unnecessary reaction using reduced-pressure growth (i.e., low-pressure growth) and a low water vapor flow rate, as disclosed, e.g., in Patent Document 1.

In contrast, in the method of the present invention, growth is performed in a temperature range (hereafter referred to as "growth mode II") exceeding the temperature range in which a ZnO single-crystal can be grown (i.e., the temperature region of growth mode I) or the unstable-growth temperature region. In other words, although the temperature is too high to grow a ZnO single-crystal using MOCVD in which DMZn and water vapor are used, an MgZnO crystal can be grown by utilizing the growth catalyst function effective at high temperature of the organometal having a Cp group. Therefore, there is a significant difference with respect to the conventional technique in terms of the growth conditions for growing an MgZnO crystal having the same Mg composition. Moreover, the difference in the material gas reaction process also causes a significant difference to, e.g., the change in crystal composition that occurs when growth conditions are changed.

For example, as shown in FIG. 29, when an MgZnO crystal is grown in a temperature range at which a ZnO single-crystal grows (i.e., growth mode I), when the VI/II ratio is increased while the flow rate of the group-II materials is kept constant, the Mg composition (x) decreases and the growth rate increases (see, comparative example-1). When the flow rate of the group-II materials is increased, film-formation vacancy defect is likely to be generated, and the crystal orientation is also likely to decrease (see, comparative example-4). Therefore, it is difficult to increase the growth rate by increasing the flow rate of the material gas.

In contrast, in the method of the present invention, it is possible to increase the flow rate of the group-II materials (DMZn, Cp2Mg) to increase the growth rate. In such an instance, the VI/II ratio decreases, but the Mg composition (x) does not change significantly (see, fourth embodiment). Also, at a temperature in or below the unstable-growth temperature region, the crystallinity decreases and film vacancy and other problems are generated. This difference in the growth mode can be explained by the abovementioned growth catalyst function of organometals having a Cp group, effective at high temperatures, used in the method of the present invention.

More specifically, in the method of the present invention, high-temperature growth is performed at a growth temperature equal to or higher than the upper limit temperature for ZnO single-crystal growth, i.e., a growth temperature equal to or higher than about 850°C, whereby sufficient energy for causing the Cp group to undergo a chain-opening reaction is supplied and it is made possible for the Cp group to readily turn into a chain hydrocarbon product on the substrate surface. Also, having the growth pressure equal to or less than 5 kPa makes it possible to suppress a polymerization reaction during the chain-opening reaction and to generate a low-molecular chain hydrocarbon product. The chain-opening reaction of the Cp group requires hydrogen element (H) for the reaction. Accordingly, water vapor is fed to the growth surface (water vapor area-flow-rate FS(H2O) : about 10 $\mu$mol $\cdot$min$^{-1}$ $\cdot$cm$^{-2}$ or greater), thereby making it possible to accelerate generation of a low-molecular chain hydrocarbon product. The chain-opening reaction of the Cp group causes active oxygen to be fed to the growth surface (i.e., "growth catalyst function"), making a stable 2-dimensional crystal growth (2D growth) possible without a shortage of oxygen being fed, even under a high-temperature, reduced-pressure condition.

As a result, it becomes possible to grow a MgZnO crystal having an excellent flatness and crystal orientation, low residual carrier concentration, and an excellent crystal quality with no residual carbon, in which formation of pits (random pits) and hillocks derived from MgZnO crystal growth is suppressed.

Fifth embodiment

[Growth method of fifth embodiment]

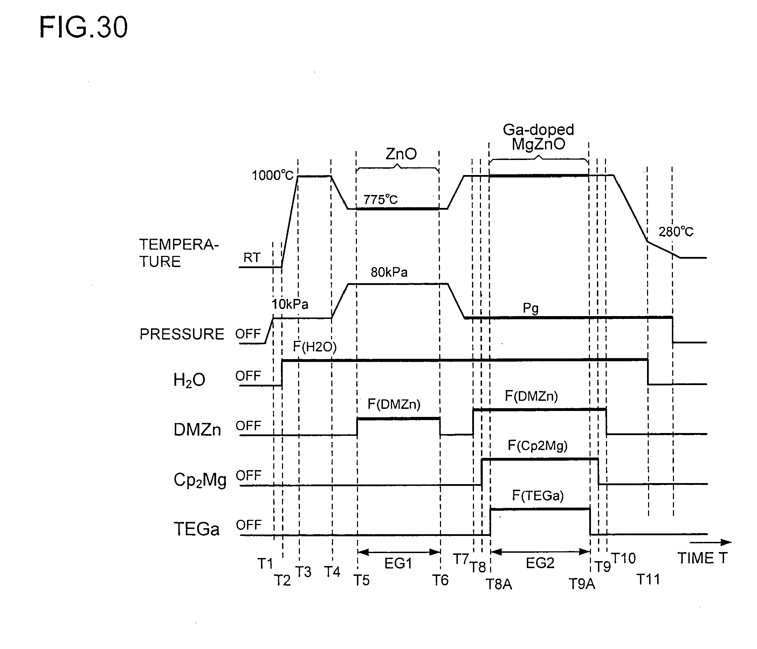

A method for growing a Ga-doped MgZnO crystal according to a fifth embodiment will now be described in detail with reference to the crystal growth sequence shown in FIG. 30. In the fifth embodiment, a Ga organometal (TEGa) was used as a dopant, a ZnO crystal was grown on a ZnO substrate, and a Ga-doped MgZnO crystal was grown on the ZnO crystal.

First, a ZnO single- crystal substrate 10 having a surface layer that has been etched was positioned on a susceptor 19 in the reaction container 39. Air was discharged until a state of vacuum is reached, then the pressure in the reaction container was adjusted to 10 kPa (i.e., at time T=T1) . The ZnO substrate 10 was rotated at a rotation speed of 10 rpm by a rotation mechanism. Nitrogen ($N_2$) gas was fed from the shower head 30 onto the ZnO substrate 10 from each of the RUN- MO line 28R and the RUN- Ox line 29R at a flow rate of 2 liters/min (total 4 liters/min) .

Next, when the pressure in the reaction container 39 had stabilized at 10 kPa, the substrate temperature was increased from room temperature (RT), nitrogen gas was fed at 2 liters/min from the RUN- MO line 28R as the carrier gas, the flow rate F (H2O) of water vapor ($H_2O$ was adjusted to 800 $\mu$mol/min, and the water vapor was fed to the ZnO substrate 10  from the RUN- Ox line 29R at a flow rate, combined with the carrier gas, of 2 liters/min. Heat treatment was then performed for 7 minutes at a substrate temperature of 1000°C (T=T3 to T4) .

Next, the pressure in the reaction container 39 was increased from 10 kPa, and the substrate temperature was increased (T=T4) . When the growth pressure Pg had stabilized at 80 kPa and the substrate temperature Tg had stabilized at a predetermined growth temperature of 775°C, the flow rate F (DMZn) of the DMZn was adjusted to 10 $\mu$mol/min, the DMZn was fed to the ZnO substrate 10 at a flow rate, combined with the nitrogen gas serving as the carrier gas, of 2 liters/min, and crystal growth was commenced (T=T5) . A ZnO crystal layer 11 having a thickness of approximately 0.2 $\mu$m was grown on the ZnO substrate 10 over a growth time of 24 minutes (T=T5 to T6, growth time: EG1 = 24 min) .

Next, an increase in substrate temperature and a decrease in pressure were commenced. When the growth pressure Pg had stabilized at 5 kPa and the substrate temperature had stabilized at growth temperature Tg=875°C, DMZn (flow rate: 30 $\mu$mol/min), Cp2Mg (flow rate F (Cp2Mg) : 1.00 $\mu$mol/min), and TEGa were sequentially fed from the RUN- MO line 28R (T=7, T=8, and T=T8A, respectively) . During this time, a total flow rate, for the MO gas and the carrier gas (nitrogen), of 2 liters/min was maintained. Also, $H_2O$ (flow rate: 800 $\mu$mol/min) was fed from the RUN- Ox line 29R to the ZnO substrate 10 at a flow rate, combined with the carrier  gas, of 2 liters/min. When 360 minutes had elapsed from the start of growth (T=T8), supply of TEGa was stopped (T=T9A), supply of Cp2Mg was stopped (T=T9) and then supply of DMZn was stopped (T=T10), and a Ga- doped MgZnO crystal layer 12 having a thickness of approximately 300 nm was grown on the ZnO crystal layer 11 (T=T8A to T9A, growth time: EG2 = 360 min) . Growth was performed six times with different TEGa flow rates F (TEGa) of 0 nmol/min (undoped), 0.03, 0.09, 0.21, 0.30, and 0.90 nmol/min (Ga- doped) .

When the growth was complete, cooling was performed (T=T10 to T11), the pressure in the container was reduced, and cooling to room temperature was performed, and the growth was completed.

[Growth condition in fifth embodiment]

As described above, in the fifth embodiment, one undoped MgZnO crystal and five Ga-doped MgZnO crystals were grown using different TEGa flow rates. As described in more detail further below, the Ga-doping concentration can be controlled by the supply flow rate F(TEGa) of TEGa. The following defines the Ga flow rate ratio (hereafter also referred to as "Ng value"), which is a molar flow rate ratio of the galliuim-based organometal relative to the group-II material gas (i.e., DMZn and Cp2Mg). Specifically, if the respective flow rates of DMZn and Cp2Mg are represented by F(DMZn) and F(Cp2Mg),

$$Ng = F(TEGa)/(F(DMZn)+F(Cp2Mg)) \qquad (Equation\ 1)$$

Specifically, in the fifth embodiment, the Ng values,  which are Ga molar flow rate ratios, were 0.0 (undoped), $0.97 \times 10^{-6}$ (F (TEGa) = 0.03 nmol/min), $2.9 \times 10^{-6}$ (0.09 nmol/min), $6.8 \times 10^{-6}$ (0.21 nmol/min), $9.7 \times 10^{-6}$ (0.3 nmol/min), and $29 \times 10^{-6}$ (0.9 nmol/min) . The group- II flow rate magnification MF (II) was 3 (i.e., x3) .

As described above, in the fifth embodiment, a magnesium-based metal-organic compound having a Cp group (Cp2Mg), a metal-organic compound that does not contain oxygen in the constituent molecule (DMZn), and water vapor ($H_2O$ were used; a gallium-based organometal (TEGa) was used as a dopant; and a Ga-doped MgZnO layer 12 was grown under the following conditions.

(i) Growth temperature Tg = 875°C
(ii) Growth pressure Pg = 5 kPa
(iii) Ng value (or, Ga flow-rate ratio): 0 (undoped), $0.97 \times 10^{-6}$, $2.9 \times 10^{-6}$, $6.8 \times 10^{-6}$, $9.7 \times 10^{-6}$, and $29 \times 10^{-6}$
(iv) Growth time: 360 mins (layer thickness: approximately 230 to 420 nm)

[Comparative example-5]

In order to evaluate the Ga-doped MgZnO crystal growth layer of the fifth embodiment, a Ga-doped MgZnO crystal was grown as comparative example-5. Growth methods such as the heat pre-treatment of the growth substrate and growth of the ZnO crystal layer 11 are identical to those according to the first embodiment; therefore, a description will be given below with regard to the growth of the MgZnO crystal layer 12. However, a heat treatment temperature of 800°C was used.

In comparative example-5, the growth temperature Tg was 775°C, and the growth pressure was 10 kPa. The flow rate F(DMZn) of DMZn was 10 μmol/min, and the flow rate F(Cp2Mg) of Cp2Mg was 0.556 μmol/min. Growth was performed five times at different TEGa flow rates F(TEGa) of 0 nmol/min (undoped), 0.02, 0.05, 0.1, and 0.2 nmol/min. In this instance, the Ng values (Ga flow-rate ratios) were 0 (undoped), $1.9 \times 10^{-6}$, $4.7 \times 10^{-6}$, $9.5 \times 10^{-6}$, and $19 \times 10^{-6}$, respectively. A Ga-doped MgZnO crystal layer having a thickness of approximately 36 to 39 nm was grown on the ZnO crystal layer 11 over a growth time of 120 minutes.

[Evaluation results of Ga-doped MgZnO crystal growth layer]

The evaluation results and properties and the like of crystal growth layers according to the fifth embodiment and comparative example-5 will now be described in detail with reference to the accompanying drawings. In order to facilitate comprehension, the crystal growth layers according to the fifth embodiment and comparative example-5 may be referred to as EMB5 and CMP5, respectively, in the following description.

<Growth layer of fifth embodiment: EMB5>

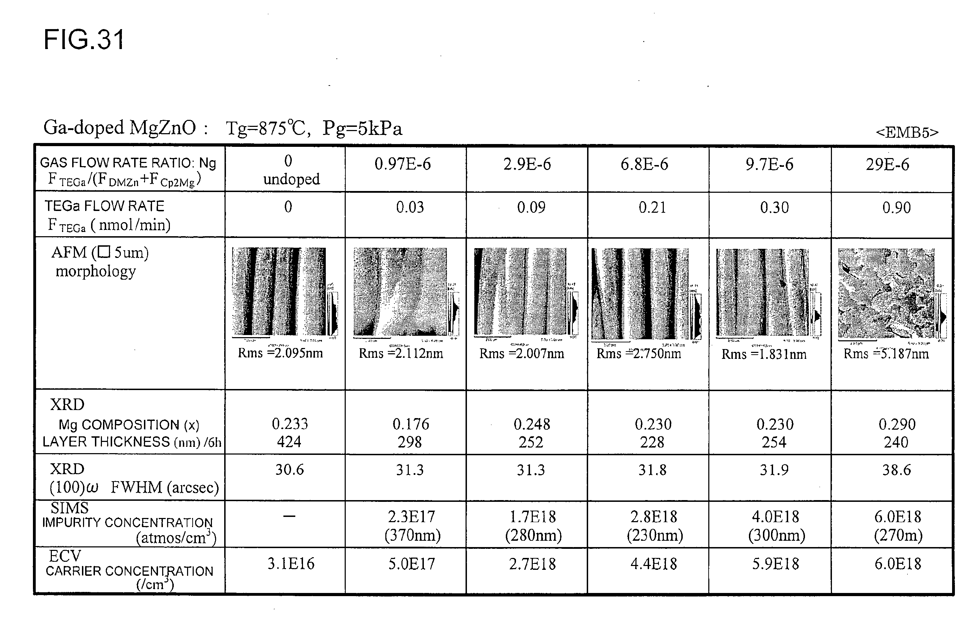

FIG. 31 shows the results of evaluations performed on the growth layers according to the fifth embodiment.

(1) Undoped MgZnO crystal

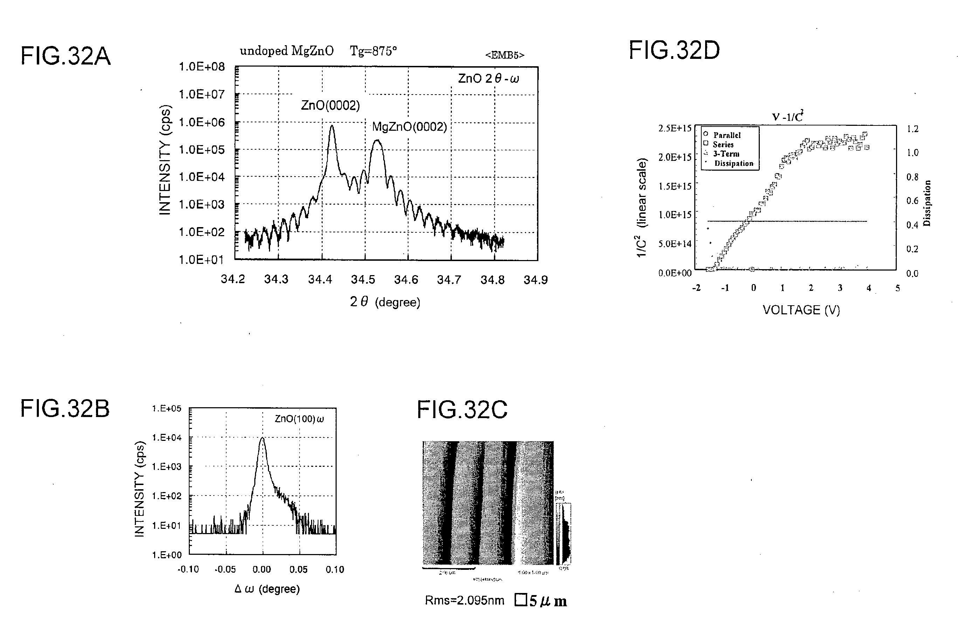

FIGS. 32A, 32B, 32C, and 32D shows the result of measuring the 2θ rocking curve of the (002)- plane, the AFM image, the rocking curve of the (100)- plane, and CV measurement results of the undoped MgZnO crystal layer (F (TEGa) =0) . It can be seen from the AFM image that a 2- dimensional (2D) growth has taken place. The surface roughness was RMS=2.09 nm due to the effect of step bunching; this can be said to correspond to a satisfactory flatness when the layer thickness of 424 nm is taken into account (FIG. 32C) . The Mg composition (x) was 0.233, and the half-width FWHM of the (100)- plane rocking curve was 30.6 arcsecs (FIG. 32B) . This FWHM of the rocking curve is equivalent to that of a ZnO substrate, and crystal orientation was regarded to be good. The residual carrier concentration was low, at $3.1 \times 10^{-16}$ cm$^{-3}$.

It is important, when adjusting the carrier concentration of the semiconductor layer, that the residual carrier concentration of the semiconductor layer be sufficiently lower than the carrier concentration to be adjusted. A carrier concentration of the p-type or n-type semiconductor layer of $1 \times 10^{17}$ to $1 \times 10^{19}$ cm$^{-3}$, is generally used, so the residual carrier concentration is preferably equal to or less than about $5 \times 10^{16}$ cm$^{-3}$ (or, equal to or less than 1/5 to 1/10 of the target carrier concentration). It shall be apparent that if the residual carrier concentration is lower, it is possible to provide the semiconductor layer so that the carrier concentration is proportional to the impurity doping amount from a lower concentration.

As described above, the present invention is based on a method in which an MgZnO crystal can be grown at a high temperature. In this growth method, a zinc- based organometal (e.g., DMZn) that does not contain oxygen, and a magnesium- based metal- organic compound having a Cp group, and water vapor are used, and growth is performed at a high temperature (i.e., growth temperature equal to or higher than 850°C) and a growth pressure of about 5 kPa or less, with the water vapor area- flow- rate FS (H2O) equal to or greater than about 10 μmol ·min$^{-1}$·cm$^{-2}$. Therefore, a growth temperature equal to or higher than 850°C is also possible for an instance in which a Ga- doped MgZnO crystal is grown.

(2) Ga-doped MgZnO crystal

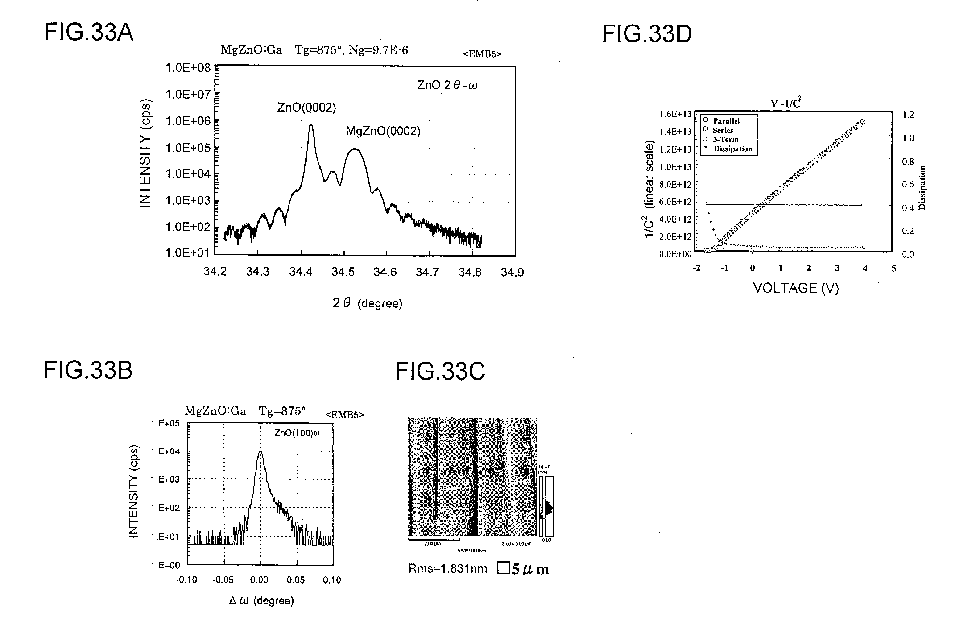

FIGS. 33A, 33B, 33C, and 33D show the result of measuring the 2θ rocking curve of the (002)- plane, the AFM image, the rocking curve of the (100)- plane, and CV measurement results for an instance in which the TEGa flow rate F (TEGa) is 0.3 nmol/min (Ng value: $9.7 \times 10^{-6}$) as a representative example of a Ga- doped MgZnO crystal layer.

As shown in the AFM images in FIG. 31, it can be seen that 2-dimensional crystal growth has taken place when the TEGa flow rate F(TEGa) was in a range of 0.03, 0.09, 0.21, and 0.30 nmol/min (i.e., Ng values of $0.97 \times 10^{-6}$, $2.9 \times 10^{-6}$, $6.8 \times 10^{-6}$, and $9.7 \times 10^{-6}$). Also, the surface roughness (RMS or Rq) was 2.11, 2.01, 2.75, and 1.83 nm respectively due to the effect of step bunching; however, these can be said to correspond to a satisfactory flatness, accounting for the fact that the film thicknesses are 298, 252, 228, and 254 nm respectively.

As shown in FIG. 31, the Mg compositions (x) were 0.176. 0.248. 0.230, and 0.230 respectively, and the FWHM values of the (100)- plane rocking curves were 31.3. 31.3, 31.8, and 31.9 arcsecs respectively for Ng values of $0.97 \times 10^{-6}$, $2.9 \times 10^{-6}$, $6.8 \times 10^{-6}$, and $9.7 \times 10^{-6}$. The FWHM values of the rocking curves were equivalent to those of a ZnO substrate, and the crystal orientation can be said to be good. The Ga- doping concentrations obtained by SIMS measurement were $2.3 \times 10^{17}$, $1.7 \times 10^{18}$, $2.8 \times 10^{18}$, and $4.0 \times 10^{18}$ atoms/cm$^3$. The carrier concentrations were $5.0 \times 10^{18}$, $2.7 \times 10^{18}$, $4.4 \times 10^{18}$, and $5.9 \times 10^{18}$ cm$^{-3}$.

As shown in FIGS. 33A, 33B, 33C, and 33D, it was found that it is possible to obtain a satisfactory 2-dimensional crystal growth performance, flatness, and crystal orientation even when Ga-doping was performed up to a level corresponding to a TEGa flow rate F(TEGa) of 0.3 nmol/min (Ng value: $9.7 \times 10^{-6}$).

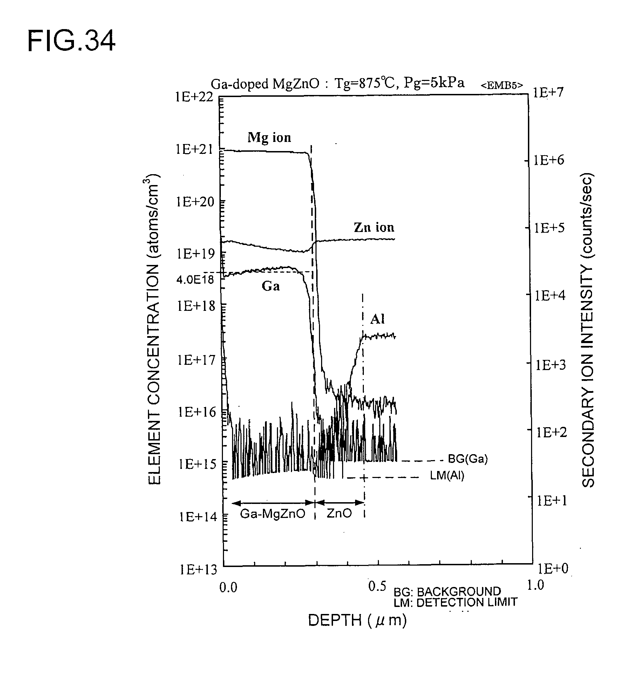

FIG. 34 shows the SIMS depth-direction analysis (i.e., depth profile) results when the TEGa flow rate F(TEGa) was 0.3 nmol/min (Ng value: $9.7 \times 10^{-6}$). It was found that according to the method of the present invention, Ga exhibits a good doping profile that is equal to or less than the lower limit of detection (indicated by LM(Ga) in the drawing) in the base ZnO crystal layer 11 and rises sharply from the interface of the MgZnO crystal layer 12. In other words, even when a Ga-doped MgZnO crystal layer is grown at a growth temperature higher than that of the base ZnO crystal layer, unintended back diffusion, i.e., diffusion into the base or underlying ZnO crystal layer, does not occur.

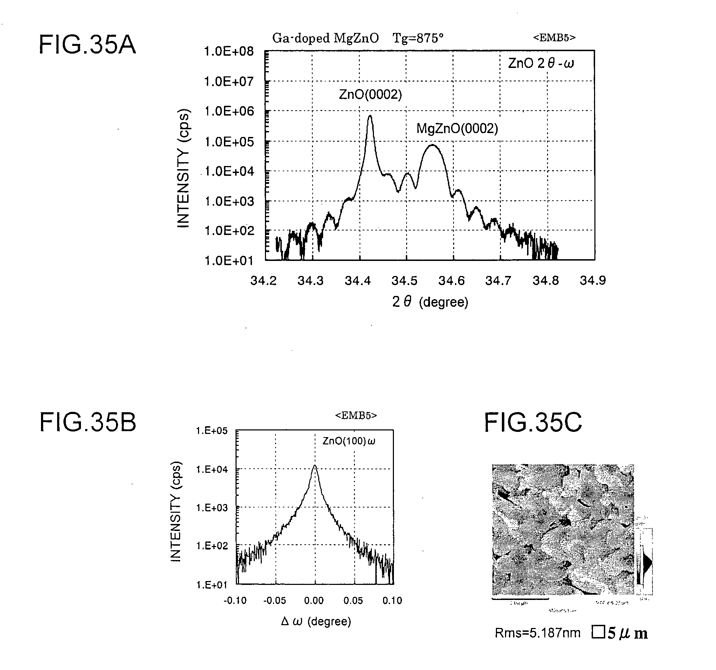

In contrast, as shown in FIGS. 35A, 35B, and 35C, when the TEGa flow rate F (TEGa) was 0.90 nmol/min (Ng value: $29 \times 10^{-6}$), the AFM image showed a 3- dimensional growth (3DG) having a non- flat surface of projections/ depressions shape (FIG. 35C), and the FWHM of the (100)- plane rocking curve was also wider at 38.6 arcsecs (FIG. 35B). A layered structure necessary for, e.g., a semiconductor light- emitting element cannot be formed using an MgZnO crystal layer having this flatness and crystallinity.

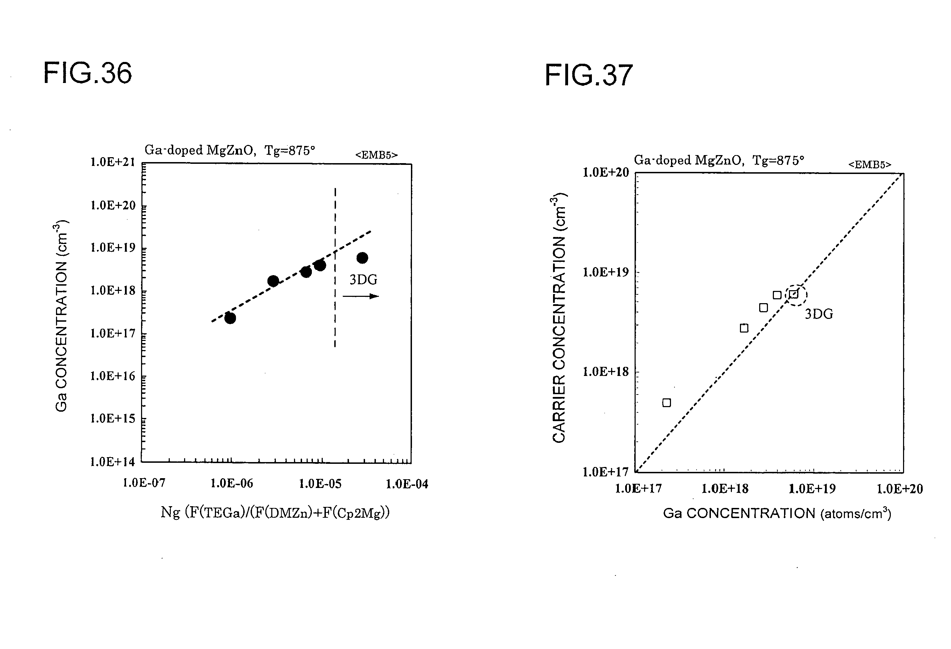

FIG. 36 shows the relationship between the Ng value and the Ga doping concentration. It was found that when the Ng value was in a range of $0.97 \times 10^{-6}$ to $9.7 \times 10^{-6}$ at which the MgZnO crystal layer exhibits flatness, the Ga doping concentration increased in proportion to the Ng value. At an Ng value of $29 \times 10^{-6}$, at which the MgZnO crystal layer becomes non-flat (3DG), the Ga doping concentration veers downwards off the fitting line.

It was also found that the upper limit of the Ng value at which flatness can be obtained is substantially constant at about $1 \times 10^{-5}$ irrespective of the growth temperature. Supplying TEGa at an Ng value equal to or less than this value makes it possible to obtain a Ga-doped MgZnO crystal layer exhibiting a good flatness.

FIG. 37 shows the relationship between the Ga doping concentration and the n-type carrier concentration. In a range in which the MgZnO crystal layer exhibits flatness, the Ga doping concentration and the n-type carrier concentration were in a good proportional relationship. This is because the residual carrier concentration of the MgZnO crystal layer is low and gallium is functioning as a good dopant (i.e., a high activation rate). The n-type carrier concentration being slightly high is considered to be caused by inherent characteristics of the measurement equipment. When the MgZnO crystal layer becomes non-flat (3DG), the Ga doping concentration decreased, and as a result the carrier concentration also decreased.

It was found that the crystal layer becomes non-flat at substantially the same TEGa flow rate (Ng value = $1 \times 10^{-5}$) at each of the growth temperatures from 850°C to 925°C. Specifically, although high-concentration doping of gallium exceeding the upper limit Ng value is not possible, as long as the Ng value is equal to or less than the upper limit, the Ga doping concentration can be adjusted by adjusting the TEGa flow rate (i.e., Ng value).

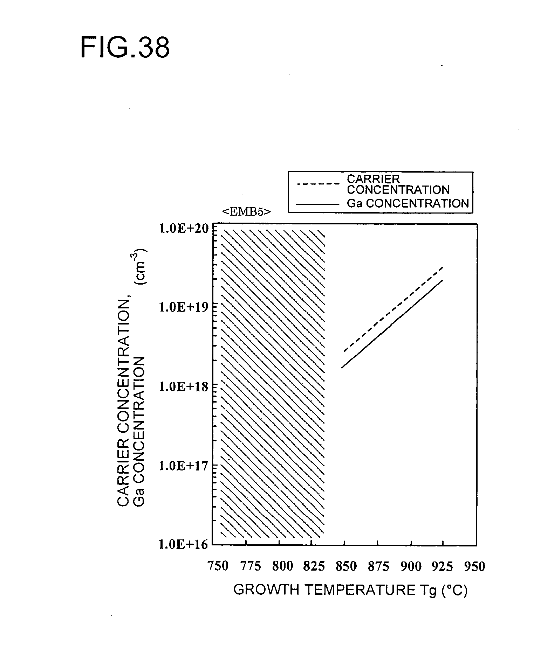

Meanwhile, as shown in FIG. 38, it was found that increasing the growth temperature Tg makes it possible to increase the Ga doping concentration and the n- type carrier concentration. Here, growth was performed with the TEGa flow rate (or, Ng value) being the upper limit of Ng values at which good flatness and crystal orientation can be obtained ($1 \times 10^{-5}$).

Specifically, at growth temperatures Tg of 850°C, 875°C, 900°C, 925°C, 950°C, and 1000°C, the Ga doping concentrations were $1.8 \times 10^{18}$, $4.0 \times 10^{18}$, $9.1 \times 10^{18}$, $2.9 \times 10^{19}$, $4.7 \times 10^{19}$, and $2.4 \times 10^{20}$ cm$^{-3}$, and the n- type carrier concentrations were $2.6 \times 10^{18}$, $5.9 \times 10^{18}$, $1.3 \times 10^{19}$, $2.9 \times 10^{19}$, $6.4 \times 10^{19}$, and $3.2 \times 10^{20}$ cm$^{-3}$. In other words, it was found that the upper limit of the n- type carrier concentration can be increased by increasing the growth temperature of the MgZnO crystal.

The upper Ga doping concentration is expressed by:

Ga doping concentration (2DG) = $10^{(0.0143 \times Tg + 6.12)}$
Carrier concentration = $10^{(0.0139 \times Tg + 6.63)}$

The constants in the formulae fluctuate somewhat depending on the growth system.

As described above, the organometal used for the n-type dopant may, instead of TEGa, be TMGa; and may also be TMA1, TEA1, or TIBA1. The Ng value, the upper limit doping concentration value, or the carrier concentration (or activation rate) will differ somewhat depending on the organometal used.

<Growth layer of comparative example-5: CMP5>

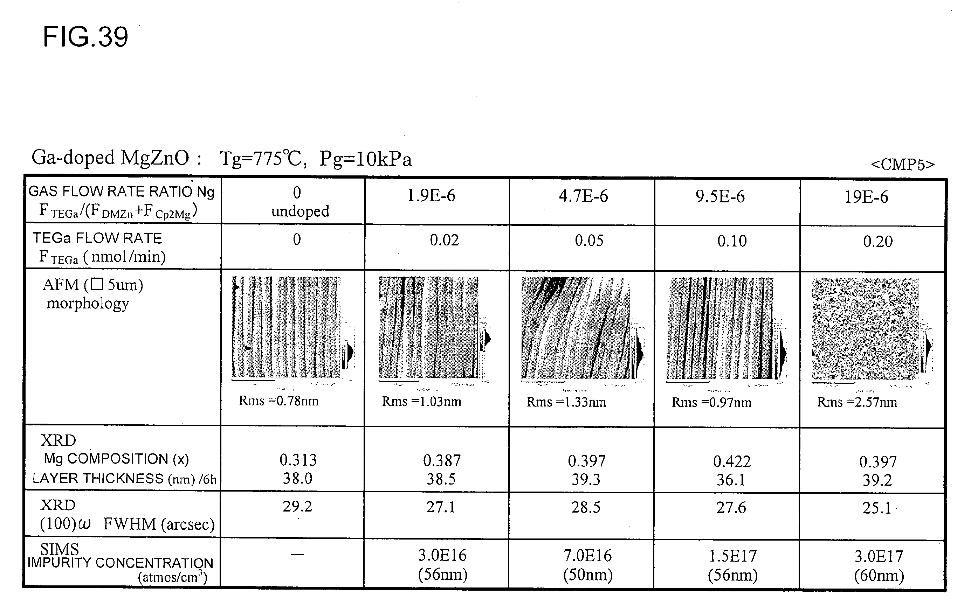

FIG. 39 shows the results of evaluations performed on the undoped and Ga- doped MgZnO crystal growth layers according to a comparative example 5. With regard to the undoped MgZnO crystal, it can be seen from the AFM image that 2- dimensional crystal growth has taken place. The surface roughness is RMS = 0.78 nm, and the flatness was satisfactory. The Mg composition (x) was 0.31, and the FWHM of the (100)- plane rocking curve was 29.2 arcsecs. This rocking- curve FWHM is equivalent to that of the substrate, and crystal orientation can be said to be good.

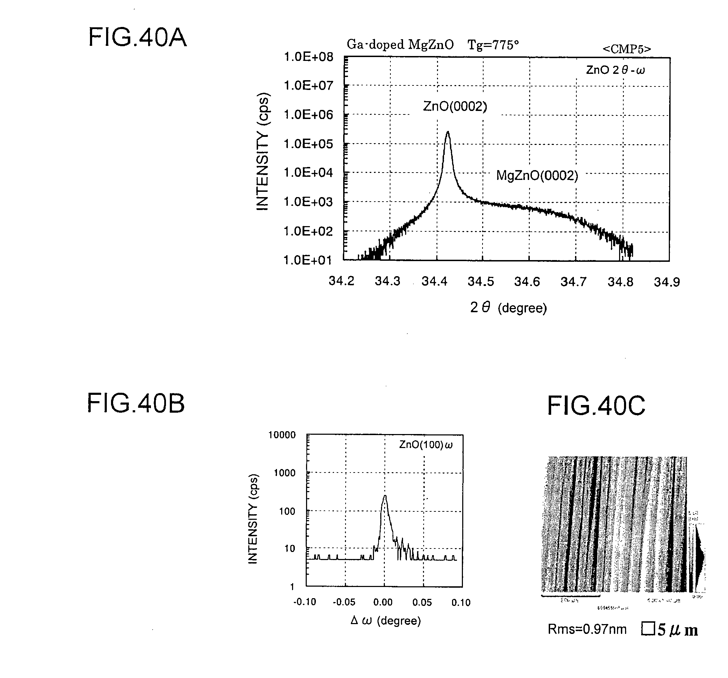

FIGs. 40A, 40B and 40C respectively show the results of measuring the $2\theta$ rocking curve of the (002)- plane, the AFM image, and the rocking curve of the (100)- plane when the TEGa flow rate F (TEGa) is 0.1 nmol/min (Ng value: $9.5 \times 10^{-6}$). It can be seen from the AFM image that 2- dimensional crystal growth has taken place in a TEGa flow rate F (TEGa) range of 0.02, 0.05, 0.10 nmol/min (Ng values of $1.9 \times 10^{-6}$, $4.7 \times 10^{-6}$, and $9.5 \times 10^{-6}$). The surface roughness (RMS or Rq) was 1.03, 1.33, and 0.97 nm, and the flatness was satisfactory.

The Mg compositions (x) were 0.387, 0.397, and 0.422, and the FWHMs of the (100)- plane rocking curve were 27.1. 28.5, and 27.6 arcsecs. These rocking curve values are equivalent to those of the ZnO substrate, and crystal orientation can be said to be good.

The Ga doping concentrations obtained by SIMS measurement were $3.0 \times 10^{16}$, $7.0 \times 10^{16}$, and $1.5 \times 10^{17}$ atoms/cm$^3$.

In contrast, when the TEGa flow rate is 0.20 nmol/min (Ng value: $19 \times 10^{-6}$), the AFM image showed a non-flat shape (3DG), and the FWHM of the (100)- plane rocking curve was 25.1, although a widening of the base was observed. A layered structure necessary for a semiconductor light- emitting element such as an LED cannot be formed using an MgZnO crystal layer in this state.

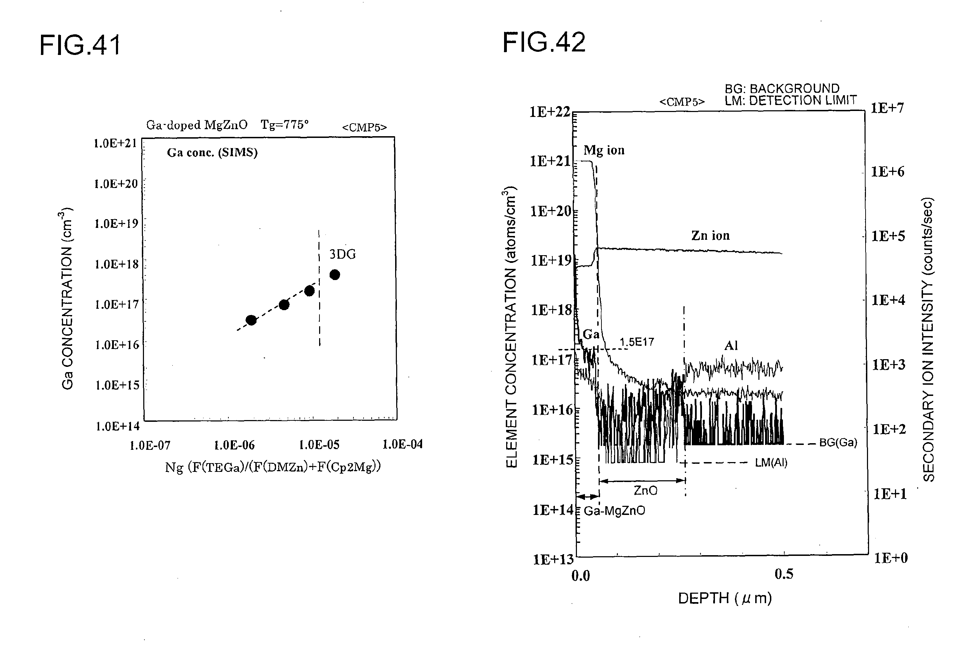

FIG. 41 shows the relationship between the Ga doping concentration and the Ng value. The Ga doping concentration increases proportionately with respect to the Ng value in an Ng value range of $1.9 \times 10^{-6}$ to $19 \times 10^{-6}$. However, when the Ng value is at $19 \times 10^{-6}$, the MgZnO crystal layer becomes non-flat.

FIG. 42 shows the SIMS depth-direction analysis results when the TEGa flow rate F(TEGa) is 0.1 nmol/min (Ng value: $9.5 \times 10^{-6}$). In the method according to comparative example-5, some diffusion to the base or underlying ZnO crystal layer occurred even though the Ga concentration in the MgZnO crystal layer was low. Also, Al in the ZnO has passed through the base ZnO crystal layer and diffused into the MgZnO layer. This is considered to be because Ga-doping has caused degradation of the crystal quality of the MgZnO crystal layer, Ga has diffused into the base ZnO layer, and the Al in the substrate has diffused into the MgZnO crystal layer.

[Crystal growth and doping characteristics of present invention]

The method of the present invention is based on growth of a high-quality MgZnO crystal having a low residual carrier concentration, made possible from knowledge relating to decomposition and reaction processes of an magnesium-based metal-organic compound having a Cp group, at a growth temperature equal to or greater than the upper limit temperature for ZnO single-crystal growth. In other words, this method was conceived from the results of examining doping performed on a high-quality MgZnO crystal.

More specifically, in the method of the present invention, a zinc-based organometal that does not contain oxygen in the constituent molecule, a magnesium-based metal-organic compound having a Cp group (Cp2Mg), a dopant organometal (TEGa), and water ($H_2O$ are used, and high-temperature growth is performed at a growth temperature equal to or greater than the upper limit temperature for ZnO single-crystal growth, i.e., equal to or greater than about 850°C, whereby it becomes possible to grow a Ga-doped MgZnO crystal having a high doping concentration and a high quality.

Specifically, the method of the present invention uses the fact that a growth temperature equal to or greater than the upper limit temperature for ZnO single- crystal growth accelerates the chain- opening reaction of the Cp group, and the chain- opening reaction providing active oxygen to the growth surface enables stable 2- dimensional crystal growth (2D growth) and enables growth of an MgZnO crystal having an excellent crystal quality, good flatness and crystal orientation, and a low carrier concentration (i.e., the "growth catalyst function"). Having the growth pressure equal to or less than about 5 kPa suppresses a polymerization reaction during the chain- opening reaction and enables generation of a low- molecular chain hydrocarbon product.

Using an MgZnO crystal growth method of such description and adding a gallium-based organometal makes it possible to grow a Ga-doped MgZnO crystal having a high doping concentration (or high carrier concentration) and a high quality, and to grow an MgZnO crystal having an n-type carrier concentration proportional to the Ga-doping concentration. This is because the residual carrier concentration of the MgZnO crystal layer is low, and gallium functions as a good dopant (i.e., a high activation rate).

As described above, it was found that if the amount of TEGa fed is equal to or less than the upper limit Ng value ($1 \times 10^{-5}$), it is possible to grow a Ga-doped MgZnO crystal having a high doping concentration and a high quality. The upper limit Ng value is substantially constant irrespective of the growth temperature, and the doping concentration (carrier concentration) can be changed by changing the growth temperature. For example, in order to form an n-type MgZnO crystal layer having a different carrier concentration, it is necessary only to change the growth temperature when growing the MgZnO crystal layer. Moreover, having a high growth temperature enhances the gallium element intake rate of the crystal, making high-concentration doping possible.

Therefore, according to the present invention, it is possible to grow a Ga- doped MgZnO crystal having a good flatness and crystal orientation, suppressed formation of random pits and hillocks, and a high carrier concentration and a high quality.

This application is based on Japanese Patent Applications No. 2012-066855 and No. 2012-066858 which are hereby incorporated by reference.

## Claims

1.　A method for growing a magnesium- zinc- oxide (MgZnO)- based crystal on a zinc oxide (ZnO)- based crystal by MOCVD; the method comprising:

　　growing an MgZnO- based single- crystal layer at a growth pressure of less than 10 kPa and a growth temperature equal to or greater than an upper limit temperature for ZnO single- crystal growth,
　　wherein said MgZnO-based single-crystal layer is grown using a magnesium-based metal-organic compound having a Cp group, water vapor ($H_2O$) and a zinc-based metal-organic compound that does not contain oxygen.

2.　The method according to claim 1, wherein said upper limit temperature for ZnO single-crystal growth is a temperature at which a film vacancy defect is generated in a grown ZnO crystal when growth is performed at a growth pressure of less than 10 kPa using said water vapor and said zinc-based metal-organic compound that does not contain oxygen.

3.　The method according to claim 1 or 2, comprising:

　　growing, on a ZnO substrate, a ZnO single-crystal layer using said water vapor and said zinc-based metal-organic compound that does not contain oxygen,
　　said MgZnO-based single-crystal layer being grown on said ZnO single-crystal layer at a growth temperature equal to or greater than said upper limit temperature, said upper limit temperature being a upper temperature for growing said ZnO single-crystal layer.

4.　The method according to any one of claims 1 to 3, wherein said MgZnO-based single-crystal layer is grown at a temperature equal to or greater than 850°C.

5.　The method according to any one of claims 1 to 4, wherein said MgZnO-based single-crystal layer is grown at a pressure equal to or less than 5 kPa.

6.　The method according to any one of claims 1 to 5, wherein said water vapor is fed at a water vapor area- flow- rate, which is a molar flow rate per unit area, equal to or greater than 10 $\mu$mol $\cdot$min$^{-1}$ $\cdot$cm$^{-2}$.

7.　The method according to any one of claims 1 to 6, wherein the Mg composition (x) of said MgZnO-based single-crystal layer is equal to or greater than 0.1.

8.　The method according to any one of claims 1 to 7, wherein a carrier gas used in growing said MgZnO-based single-crystal layer is an inert gas.

9.　The method according to claim 1, wherein:

　　a metal-organic compound containing an impurity element is further used in growing said MgZnO-based single-crystal layer to grow an impurity-doped MgZnO-based single-crystal layer.

10. The method according to claim 9, wherein said impurity-doped MgZnO-based single-crystal layer is grown at a temperature equal to or greater than 850°C.

11. The method according to claim 9 or 10, wherein a functional group of said metal-organic compound containing said impurity element is a chain hydrocarbon group.

12. The method according to any one of claims 9 to 11, wherein said metal-organic compound containing said impurity element is TEGa.

13. The method according to any one of claims 9 to 12, wherein:

said zinc-based metal-organic compound that does not contain oxygen is DMZn, and said magnesium-based metal-organic compound having a Cp group is Cp2Mg; and
when the molar flow rate of said TEGa, said DMZn, and said Cp2Mg is represented by F(TEGa), F(DMZn), and F(Cp2Mg), Ga flow rate Ng, which is a molar flow rate ratio of said TEGa relative to said DMZn and said Cp2Mg, satisfies the following relationship:

$$\text{Ng} = \text{F(TEGa)}/(\text{F(DMZn)} + \text{F(Cp2Mg)}) \leq 1 \times 10^{-5}$$

14. The method according to any one of claims 9 to 13, wherein:

the step of growing said MgZnO-based single-crystal layer includes a step for changing the growth temperature to grow said impurity-doped MgZnO-based single-crystal layer.

15. The method according to any one of claims 9 to 14, comprising:

growing a ZnO single-crystal layer on a ZnO substrate using a zinc-based metal-organic compound that does not contain oxygen, and water vapor;
said impurity-doped MgZnO-based single-crystal layer being grown on said ZnO single-crystal layer at a growth temperature equal to or greater than said upper limit temperature, said upper limit temperature being a upper temperature for growing said ZnO single-crystal layer.

# FIG.1

EP 2 641 996 A1

# FIG.2

# FIG.3

EP 2 641 996 A1

# FIG.4

undoped MgZnO <EMB1>

| GROWTH TEMPERATURE Tg | 850 ℃ | 863 ℃ | 875 ℃ | 888 ℃ | 900 ℃ |
|---|---|---|---|---|---|
| GROWTH PRESSURE Pg | 5kPa  MF(II)=3 | 5kPa  MF(II)=3 | 5kPa  MF(II)=3 | 5kPa  MF(II)=3 | 5kPa  MF(II)=3 |
| XRD | x=0.17<br>t=514 nm/8h<br>(100)$\omega$ =29.7 arcsec | x=0.20<br>t=494 nm /8h<br>(100)$\omega$ =33.9 arcsec | x=0.23<br>t=498 nm /8h<br>(100)$\omega$ =27.5 arcsec | x=0.27<br>t=483 nm /8h<br>(100)$\omega$ =29.4 arcsec | x=0.30<br>t=528 nm /8h<br>(100)$\omega$ =30.3 arcsec |
| AFM image<br>a-AXIS ☐15nm<br><11-20><br>m-AXIS<br><10-10><br>c-AXIS<br>< 0001> ☐5nm | Rms =1.469nm | Rms =2.092nm | Rms =1.462nm | Rms =1.310nm | Rms =1.652nm |
|  | Rms =1.379nm | Rms =1.319nm | Rms =1.101nm | Rms =1.107nm | Rms =1.269nm |
| ☐1nm | Rms =0.775nm | Rms =0.830nm | Rms =0.977nm | Rms =1.239nm | Rms =0.639nm |

FIG.5

<EMB1>

| | Tg = 850 ℃<br>P = 5kPa | Tg = 863 ℃<br>P = 5kPa | Tg = 875 ℃<br>P = 5kPa | Tg = 888 ℃<br>P = 5kPa | Tg = 900 ℃<br>P = 5kPa |
|---|---|---|---|---|---|
| ×20 | pit=9<br>200um | pit=0 | pit=2 | pit=22 | pit=25 |
| | PIT DENSITY<br>=6.3E3 cm$^{-2}$ | PIT DENSITY<br><7.3E3 cm$^{-2}$ | PIT DENSITY<br>=1.4E3 cm$^{-2}$ | PIT DENSITY<br>=1.5E4 cm$^{-2}$ | PIT DENSITY<br>=1.7E4 cm$^{-2}$ |
| ×50 | 50um | | | | |

EP 2 641 996 A1

EP 2 641 996 A1

FIG.6A

FIG.6B

<EMB1>

**XRD 2θ scan**   Layer stack
MgZnO / ZnO/ ZnO sub.

ZnO(0002)   MgZnO(0002)

x

0.30

0.27

0.23

0.20

0.17

Tg

900deg

888deg

875deg

863deg

850deg

XRD INTENSITY (a.u.)

34.3   34.4   34.5   34.6   34.7   34.8

DIFFRACTION ANGLE ω (degree)

<EMB1>

(100)ω rocking curves
Layer stack
MgZnO/ZnO/ZnO sub.

FWHM

30.3arcsec

29.4arcsec

27.5arcsec

33.9arcsec

29.7arcsec

Tg

900deg.

888deg.

875deg.

863deg.

850deg.

XRD INTENSITY (a.u.)

0.1   0   + 0

DIFFRACTION ANGLE ω (degree)

## FIG.7

FIG.9

<EMB1>

FIG.8

<EMB1>

FIG.10A

FIG.10B

33

# FIG.11

undoped MgZnO <EMB2>

| GROWTH TEMPERATURE Tg | 775 | 825 | 875 | 925 |
|---|---|---|---|---|
| MF(II) GROWTH PRESSURE Pg | ×3 5kPa | ×3 5kPa | ×3 5kPa | ×3 5kPa |
| XRD | x = 0.028 | x = 0.099 | x = 0.235 | x = 0.375 |
| AFM image | (100)$\omega$ =49.3 arcsec | (100)$\omega$ =30.3 arcsec | (100)$\omega$ =27.2 arcsec | (100)$\omega$ =29.6 arcsec |
| □ 15nm | Rms =25.3nm | Rms =1.14nm | Rms =2.48nm | Rms =1.41nm |
| □ 5nm | Rms =10.5nm | Rms =0.975nm | Rms =0.692nm | Rms =1.12nm |
| □ 1nm | Rms =0.298nm | Rms =0.865nm | Rms =0.523nm | Rms =1.01nm |

EP 2 641 996 A1

# FIG.12

<EMB2>

| $Tg = 775\,°C$ | $Tg = 825\,°C$ | $Tg = 875\,°C$ | $Tg = 925\,°C$ |
|---|---|---|---|
| | | | |
| FILM VACANCY | HILLOCKS & PITS PIT DENSITY 6.9E4 cm$^{-2}$ | HILLOCKS & PITS PIT DENSITY 1.4E3 cm$^{-2}$ | HILLOCKS & PITS PIT DENSITY 8.6E3 cm$^{-2}$ |
| | | | |
| FWHM = 49.3 arcsec | FWHM = 30.3 arcsec | FWHM = 27.2 arcsec | FWHM = 29.6 arcsec |

# FIG.13

undoped MgZnO    GROWTH TEMPERATURE Tg = 875°C

EP 2 641 996 A1

<EMB3>

| GROWTH PRESSURE Pg | 2kPa | 5kPa | 10kPa | 20kPa | 40kPa |
|---|---|---|---|---|---|
| MF(II) F(H2O) | ×1 640 µmol/min | ×1 640 µmol/min | ×1 640 µmol/min | ×1 640 µmol/min | ×1 640 µmol/min |
| XRD<br><br>AFM image<br><br>☐ 15nm | x = 0.34<br>t=22.2nm /2h<br>(100)$\omega$ =27.6 arcsec<br><br><br>Rms =1.14nm | x = 0.34<br>t=22.7nm /2h<br>(100)$\omega$ =28.9 arcsec<br><br><br>Rms =1.14nm | x = 0.29<br>t=30.5nm /2h<br>(100)$\omega$ =43.6 arcsec<br><br><br>Rms =7.93nm | x = 0.31<br>t=16.0nm /2h<br>(100)$\omega$ =44.0 arcsec<br><br><br>Rms =18.44nm | NO GROWTH |
| ☐ 5nm | <br>Rms =0.947nm | <br>Rms =1.06nm | <br>Rms =9.26nm | <br>Rms =18.79nm | |
| ☐ 1nm | <br>Rms =0.881nm | <br>Rms =1.12nm | <br>Rms =2.025nm | <br>Rms =17.18nm | |

FIG.14

<EMB3>

| Pg = 2 kPa | Pg = 5 kPa | Pg = 10 kPa | Pg = 20 kPa |
|---|---|---|---|
| FWHM = 27.6 arcsec | FWHM = 28.9 arcsec | FWHM = 43.6 arcsec | FWHM = 44.0 arcsec |

FIG.15

<EMB3>

2 D ← → FILM VACANCY

GROWTH TEMPERATURE Pg (kPa)

# FIG.16

Tg =875 ℃, Pg=5kPa
<EMB4>

| MF(II)<br>F(DMZn)<br>F(Cp2Mg)<br>F(H2O) | 【×1】<br>10 μmol/min<br>0.334 μmol/min<br>640 μmol/min | 【×2】<br>20 μmol/min<br>0.669 μmol/min<br>640 μmol/min | 【×3】<br>30 μmol/min<br>1.00 μmol/min<br>640 μmol/min | 【×4】<br>40 μmol/min<br>1.33 μmol/min<br>800 μmol/min |
|---|---|---|---|---|
| VI／II | 61.9 | 31.0 | 20.6 | 19.4 |
| XRD<br><br><br>AFM image<br>□ 15nm | x=0.34<br>t=22.7nm /2h<br>(100)ω =28.9 arcsec<br><br>Rms =1.14nm | x=0.30<br>t=57.9nm /2h<br>(100)ω =26.5 arcsec<br><br>Rms =1.68nm | x=0.29<br>t=91.3nm /2h<br>(100)ω =26.3 arcsec<br><br>Rms =0.898nm | x=0.26<br>t=111.8nm /2h<br>(100)ω =29.9 arcsec<br><br>Rms =1.343nm |
| □ 5nm | <br>Rms =1.06nm | <br>Rms =1.27nm | <br>Rms =0.675nm | <br>Rms =0.953nm |
| □ 1nm | <br>Rms =1.12nm | <br>Rms =0.705nm | <br>Rms =0.438nm | <br>Rms =0.643nm |

EP 2 641 996 A1

FIG.17

FIG.18

# FIG.19

EP 2 641 996 A1

Tg = 775 °C, Pg = 10kPa                                                                          <CMP1>

| F(H2O)<br>VI/II RATIO | 40 $\mu$ mol/min<br>3.8 | 80 $\mu$ mol/min<br>7.6 | 160 $\mu$ mol/min<br>15.2 | 320 $\mu$ mol/min<br>30.3 | 640 $\mu$ mol/min<br>60.6 |
|---|---|---|---|---|---|
| XRD | x=0.32<br>t=60nm/2h<br>$(100)\omega$ = 22.35 arcsec | x=0.26<br>t=84.5nm/2h<br>$(100)\omega$ = 31.90 arcsec | x=0.157<br>t=138nm/2h<br>$(100)\omega$ = 23.60 arcsec | x=0.137<br>t=142nm/2h<br>$(100)\omega$ = 33.99 arcsec | x=0.108<br>t=240nm/2h<br>$(100)\omega$ = 30.72 arcsec |
| AFM image<br>□ 15nm | <br>Rms =1.63nm | <br>Rms =1.59nm | <br>Rms =1.14nm | <br>Rms =1.00nm | <br>Rms =1.09nm |
| □ 5nm | <br>Rms =1.83nm | <br>Rms =1.17nm | <br>Rms =0.78nm | <br>Rms =0.70nm | <br>Rms =0.61nm |
| □ 1nm | <br>Rms =1.38nm | <br>Rms =0.38nm | <br>Rms =0.63nm | <br>Rms =0.64nm | <br>Rms =0.15nm |

FIG.20

# FIG.21

Pg = 10kPa  <CMP2>

| GROWTH TEMPERATURE Tg (°C) | 700 | 750 | 775 | 800 | 825 | 850 |
|---|---|---|---|---|---|---|
| F(Cp2Mg) Xg | 0.556 μmol/min 0.053 | 0.556 μmol/min 0.053 | 0.556 μmol/min 0.053 | 0.556 μmol/min 0.053 | 0.334 μmol/min 0.032 | 0.334 μmol/min 0.032 |
| XRD | x=0.036 t=599nm/2h (100)$\omega$ =81.26 as | x=0.053 t=386nm/2h (100)$\omega$ =27.30 as | x=0.108 t=240nm/2h (100)$\omega$ =30.72 as | x=0.155 t=119nm/2h (100)$\omega$ =38.16 as | x= 0.192 t = 56.5 nm (100)$\omega$ = 28.0 as | x= 0.25 t = 35.7 nm /2h (100)$\omega$ = 33.0 as |
| AFM image □15nm | Rms =111.9nm | Rms =2.29nm | Rms =1.09nm | Rms =5.10nm | Rms =1.31nm | Rms =4.23nm |
| □5nm | Rms =93.84nm | Rms =1.23nm | Rms =0.61nm | Rms =3.46nm | Rms =0.726nm | Rms =2.024nm |
| □1nm | Rms =24.66nm | Rms =0.21nm | Rms =0.15nm | Rms =0.76nm | Rms =0.345nm | Rms =1.19nm |

EP 2 641 996 A1

# FIG.22

<CMP2>

| Tg=700 ℃ | Tg=750 ℃ | Tg=775 ℃ | Tg=800 ℃ | Tg=825 ℃ | Tg=850 ℃ |
|---|---|---|---|---|---|
| P=10kPa<br>Time(min) =120<br>$F_{DMZn}$ (umol)= 10<br>$F_{Cp2Mg}$ (umol) = 0.556<br>$F_{H2O}$ (umol) =640 | P=10kPa<br>Time(min) =120<br>$F_{DMZn}$ (umol)= 10<br>$F_{Cp2Mg}$ (umol) = 0.556<br>$F_{H2O}$ (umol) =640 | P=10kPa<br>Time(min) =120<br>$F_{DMZn}$ (umol)= 10<br>$F_{Cp2Mg}$ (umol) = 0.556<br>$F_{H2O}$ (umol) =640 | P=10kPa<br>Time(min) =120<br>$F_{DMZn}$ (umol)= 30<br>$F_{Cp2Mg}$ (umol) = 0.556<br>$F_{H2O}$ (umol) =640 | P=10kPa<br>Time(min) =120<br>$F_{DMZn}$ (umol)= 10<br>$F_{Cp2Mg}$ (umol) = 0.334<br>$F_{H2O}$ (umol) =640 | P=10kPa<br>Time(min) =120<br>$F_{DMZn}$ (umol)= 10<br>$F_{Cp2Mg}$ (umol) = 0.336<br>$F_{H2O}$ (umol) =640 |
| ×50 | ×50 | ×50 | ×50 | ×50 | ×50 |
| 3D ×100 | pit=28 ×100 | pit=15 ×100 | pit=10 ×100 | pit=1 ×100 | 膜欠損 ×100 |
| PIT DENSITY<br>= *.*E* $cm^{-2}$ | PIT DENSITY<br>= 4.7E5 $cm^{-2}$ | PIT DENSITY<br>=2.5E5 $cm^{-2}$ | PIT DENSITY<br>=1.7E5 $cm^{-2}$ | PIT DENSITY<br>=1.7E4 $cm^{-2}$ | PIT DENSITY<br>=*.*E* $cm^{-2}$ |

FIG.23

# FIG.24

Tg = 775 ℃                                                                 <CMP3>

| GROWTH PRESSURE Pg | 10 kPa | 20 kPa | 40 kPa |
|---|---|---|---|
| Xg<br>VI/II RATIO | 0.053<br>60.6 | 0.053<br>60.6 | 0.053<br>60.6 |
| XRD | x=0.108<br>t=240nm/2h<br>$(100)\omega$ =30.72 arcsec | x=0.065<br>t=263nm/2h<br>$(100)\omega$ = 25.46 arcsec | x= TRACE<br>t = MEASUREMENT NOT POSSIBLE<br>$(100)\omega$ = 41.38 arcsec |
| AFM image<br>□ 15um | Rms =1.09nm | Rms =1.36nm | Rms =16.07nm |
| □ 5um | Rms =0.61nm | Rms =0.84nm | Rms =8.36nm |
| □ 1um | Rms =0.15nm | Rms =1.18nm | Rms =0.71nm |

EP 2 641 996 A1

FIG.25

FIG.26

# FIG.27

Tg = 775 ℃,  Pg = 10kPa                                                    \<CMP4\>

| MF(II+VI)<br>F(DMZn)<br>F(Cp2Mg)<br>F(H2O) | 【×1】<br>10 $\mu$ mol/min<br>0.556 $\mu$ mol/min<br>40 $\mu$ mol/min | 【×2】<br>20 $\mu$ mol/min<br>1.11 $\mu$ mol/min<br>80 $\mu$ mol/min | 【×3】<br>30 $\mu$ mol/min<br>1.66 $\mu$ mol/min<br>120 $\mu$ mol/min |
|---|---|---|---|
| XRD<br><br>AFM image<br><br>☐ 15nm | x=0.413<br>t= 36.25 nm /2h<br>(100)$\omega$ =26.8:narrow<br><br>Rms =2.87nm | x=0.295<br>t= 92 nm /2h<br>(100)$\omega$ =313 :wide<br><br>Rms =5.97nm | x=0.154<br>t= 142.96 nm /2h<br>(100)$\omega$ =28.7 :wide<br><br>Rms =5.62nm |
| ☐ 5nm | <br>Rms =0.74nm | <br>Rms =4.60nm | <br>Rms =5.65nm |
| ☐ 1nm | <br>Rms =0.51nm | <br>Rms =1.17nm | <br>Rms =0.94nm |

EP 2 641 996 A1

# FIG.28

<CMP4>

| MF(II+VI) 【×1】 | MF(II+VI) 【×2】 | MF(II+VI) 【×3】 |
|---|---|---|
| F(DMZn) = 10 $\mu$mol/min | F(DMZn) = 20 $\mu$mol/min | F(DMZn) = 30 $\mu$mol/min |
| F(Cp2Mg) = 0.556 $\mu$mol/min | F(Cp2Mg) = 1.11 $\mu$mol/min | F(Cp2Mg) = 1.66 $\mu$mol/min |
| F(H2O) = 40 $\mu$mol/min | F(H2O) = 80 $\mu$mol/min | F(H2O) = 120 $\mu$mol/min |

FWHM = 26.76 arcsec          FWHM = 31.33 arcsec          FWHM = 28.73 arcsec

FIG.29

# FIG.30

EP 2 641 996 A1

# FIG.31

Ga-doped MgZnO :  Tg=875°C,  Pg=5kPa

EP 2 641 996 A1

| GAS FLOW RATE RATIO: Ng $F_{TEGa}/(F_{DMZn}+F_{Cp2Mg})$ | 0 undoped | 0.97E-6 | 2.9E-6 | 6.8E-6 | 9.7E-6 | 29E-6 |
|---|---|---|---|---|---|---|
| TEGa FLOW RATE $F_{TEGa}$ ( nmol/min) | 0 | 0.03 | 0.09 | 0.21 | 0.30 | 0.90 |
| AFM (□5um) morphology | Rms =2.095nm | Rms =2.112nm | Rms =2.007nm | Rms =2.750nm | Rms =1.831nm | Rms =5.187nm |
| XRD Mg COMPOSITION (x) LAYER THICKNESS (nm) /6h | 0.233 424 | 0.176 298 | 0.248 252 | 0.230 228 | 0.230 254 | 0.290 240 |
| XRD (100)$\omega$ FWHM (arcsec) | 30.6 | 31.3 | 31.3 | 31.8 | 31.9 | 38.6 |
| SIMS IMPURITY CONCENTRATION (atmos/cm³) | — | 2.3E17 (370nm) | 1.7E18 (280nm) | 2.8E18 (230nm) | 4.0E18 (300nm) | 6.0E18 (270m) |
| ECV CARRIER CONCENTRATION (/cm³) | 3.1E16 | 5.0E17 | 2.7E18 | 4.4E18 | 5.9E18 | 6.0E18 |

FIG.32A

FIG.32B

FIG.32C

FIG.32D

FIG.33D

FIG.33A

FIG.33C

FIG.33B

FIG.34

FIG.35A

Ga-doped MgZnO  Tg=875°                    <EMB5>

ZnO 2θ-ω

ZnO(0002)

MgZnO(0002)

INTENSITY (cps)

2θ (degree)

FIG.35B

<EMB5>

ZnO(100)ω

INTENSITY (cps)

Δω (degree)

FIG.35C

Rms=5.187nm  □5μm

FIG.37

FIG.36

FIG.38

# FIG.39

Ga-doped MgZnO :  Tg=775℃,  Pg=10kPa

<CMP5>

| GAS FLOW RATE RATIO Ng $F_{TEGa}/(F_{DMZn}+F_{Cp2Mg})$ | 0 undoped | 1.9E-6 | 4.7E-6 | 9.5E-6 | 19E-6 |
|---|---|---|---|---|---|
| TEGa FLOW RATE $F_{TEGa}$ ( nmol/min) | 0 | 0.02 | 0.05 | 0.10 | 0.20 |
| AFM (□ 5um) morphology | Rms =0.78nm | Rms =1.03nm | Rms =1.33nm | Rms =0.97nm | Rms =2.57nm |
| XRD Mg COMPOSITION (x) LAYER THICKNESS (nm) /6h | 0.313 38.0 | 0.387 38.5 | 0.397 39.3 | 0.422 36.1 | 0.397 39.2 |
| XRD (100)$\omega$  FWHM (arcsec) | 29.2 | 27.1 | 28.5 | 27.6 | 25.1 |
| SIMS IMPURITY CONCENTRATION (atmos/cm$^3$) | — | 3.0E16 (56nm) | 7.0E16 (50nm) | 1.5E17 (56nm) | 3.0E17 (60nm) |

EP 2 641 996 A1

FIG.40A

Ga-doped MgZnO    Tg=775°                    <CMP5>

FIG.40B                                    FIG.40C

Rms=0.97nm    □5μm

FIG.42

FIG.41

Europäisches
Patentamt

European
Patent Office

Office européen
des brevets

## EUROPEAN SEARCH REPORT

Application Number

EP 13 00 1444

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2010/295039 A1 (HORIO NAOCHIKA [JP] ET AL) 25 November 2010 (2010-11-25)<br>* "third embodiment" *<br>* figure 5 *<br>* paragraphs [0062], [0064], [0246], [0247] *<br>----- | 1-15 | INV.<br>C23C16/18<br>C30B25/16<br>C30B25/18<br>C23C16/40<br>C30B29/22<br>C23C16/52 |
| A | US 2010/064966 A1 (HORIO NAOCHIKA [JP] ET AL) 18 March 2010 (2010-03-18)<br>* the whole document *<br>----- | 1-15 | |
| A | WO 2010/033910 A1 (LUMENZ LLC [US]; PIERCE JONATHAN [US]; TARASCHI GIANNI [US]; ADEKORE B) 25 March 2010 (2010-03-25)<br>* the whole document *<br>----- | 1-15 | |
| A | WO 2009/143226 A1 (LUMENZ INC; ADEKORE BUNMI T [US]; PIERCE JONATHAN [US]) 26 November 2009 (2009-11-26)<br>* the whole document *<br>----- | 1-15 | |
| | | | **TECHNICAL FIELDS SEARCHED (IPC)**<br>C23C<br>C30B |

The present search report has been drawn up for all claims

| Place of search | Date of completion of the search | Examiner |
|---|---|---|
| The Hague | 25 June 2013 | Schmitt, Christian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 641 996 A1**

## ANNEX TO THE EUROPEAN SEARCH REPORT
## ON EUROPEAN PATENT APPLICATION NO.

EP 13 00 1444

25-06-2013

| Patent document cited in search report | | Publication date | Patent family member(s) | | Publication date |
|---|---|---|---|---|---|
| US 2010295039 | A1 | 25-11-2010 | JP | 2010272807 A | 02-12-2010 |
| | | | US | 2010295039 A1 | 25-11-2010 |
| US 2010064966 | A1 | 18-03-2010 | NONE | | |
| WO 2010033910 | A1 | 25-03-2010 | EP | 2253988 A1 | 24-11-2010 |
| | | | TW | 201027801 A | 16-07-2010 |
| | | | US | 2010133529 A1 | 03-06-2010 |
| | | | WO | 2010033910 A1 | 25-03-2010 |
| WO 2009143226 | A1 | 26-11-2009 | EP | 2304780 A1 | 06-04-2011 |
| | | | JP | 2011521477 A | 21-07-2011 |
| | | | TW | 201006014 A | 01-02-2010 |
| | | | US | 2011062440 A1 | 17-03-2011 |
| | | | WO | 2009143226 A1 | 26-11-2009 |
| | | | WO | 2009143229 A1 | 26-11-2009 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010272807 A
- JP 2006073726 A
- JP 2008244011 A
- JP 2008243987 A
- JP 2010010629 A
- JP 2012066855 A
- JP 2012066858 A

**Non-patent literature cited in the description**

- Handotai Book. Ohm-sha, Ltd, 265